# EUROPEAN PATENT APPLICATION

(11) **EP 4 661 223 A1**
(43) Date of publication of application: **10.12.2025**
(21) Application number: 24749940.3
(22) Date of filing: 16.01.2024
(51) Int. Cl.: H01S 5/02355, H01S 5/11, H01S 5/18, H01S 5/042

(54) **LIGHT SOURCE DEVICE**

(30) Priority: 02.02.2023 JP 2023014728
(71) Applicant: Sony Semiconductor Solutions Corporation, Atsugi-shi, Kanagawa 243-0014 (JP); Kyoto University, Kyoto-shi, Kyoto 606-8317 (JP)
(72) Inventor: KOMATSUBARA, Nozomu, Atsugi-shi, Kanagawa 243-0014 (JP); MAEDA, Osamu, Atsugi-shi, Kanagawa 243-0014 (JP); YAMAGUCHI, Keiji, Atsugi-shi, Kanagawa 243-0014 (JP); YAMADA, Kazuyoshi, Atsugi-shi, Kanagawa 243-0014 (JP); NAKAMURA, Masashi, Atsugi-shi, Kanagawa 243-0014 (JP); NODA, Susumu, Kyoto-shi, Kyoto 606-8317 (JP); ISHIZAKI, Kenji, Kyoto-shi, Kyoto 606-8317 (JP); DE ZOYSA, Menaka, Kyoto-shi, Kyoto 606-8317 (JP); INOUE, Takuya, Kyoto-shi, Kyoto 606-8317 (JP); SAKATA, Ryoichi, Kyoto-shi, Kyoto 606-8317 (JP)
(74) Representative: D Young & Co LLP
(86) International application number: PCT/JP2024/001004
(87) International publication number: WO 2024/161986

(57) **Abstract**

A light source apparatus according to the present technology includes a photonic crystal-surface emitting laser and a laser driver. The photonic crystal-surface emitting layer includes at least one light-emitting element in which a plurality of layers is stacked. The plurality of layers includes an active layer and a photonic crystal layer. The laser driver is electrically coupled to the photonic crystal-surface emitting laser through a bump. With the light source apparatus according to the present technology, it is possible to provide a light source apparatus that makes it possible to narrow beam divergence of output light, and also to achieve a reduced size and a reduced inductance.

## Description

### Technical Field

The technique (hereinafter, also referred to as "present technology") according to the present disclosure relates to a light source apparatus.

### Background Art

Typically, there is known a photonic crystal-surface emitting laser (Photonic Crystal-Surface Emitting Laser: PCSEL) including a photonic crystal (Photonic Crystal) provided on or around an active layer. In recent years, the photonic crystal-surface emitting laser has been increasingly applied to industries such as range sensors or optical communication. The photonic crystal-surface emitting laser is a device having general advantages such as a reduced size or long service life that a semiconductor laser such as a vertical cavity surface emitting laser (VCSEL) has. In addition, the photonic crystal-surface emitting laser has a photonic crystal structure that brings an advantage in which it is possible to emit light having narrow beam divergence, which is an advantage that other surface emitting lasers (for example, VCSEL) do not have.

For example, Patent Literature 1 proposes a projector (light source apparatus) in which a PCSEL is electrically coupled to a laser driver through wire bonding.

For example, Patent Literature 2 proposes a light source apparatus in which a VCSEL is electrically coupled to a laser driver through flip chip.

### Citation List

### Patent Literature

Patent Literature 1: Japanese Unexamined Patent Application Publication No. 2020-30308
Patent Literature 2: Japanese Unexamined Patent Application Publication No. 2021-82782

### Summary of the Invention

However, in a case of the existing light source apparatus, there is room for improvement in terms of narrowing the beam divergence of the output light and achieving a reduction in the size and a reduction in the inductance.

For this reason, a main object of the present technology is to provide a light source apparatus that makes it possible to narrow the beam divergence of the output light and achieve a reduction in the size and a reduction in the inductance.

The present technology provides a light source apparatus including:
a photonic crystal-surface emitting laser including at least one light-emitting element in which a plurality of layers is stacked, the plurality of layers including an active layer and a photonic crystal layer; and
a laser driver electrically coupled to the photonic crystal-surface emitting laser through a bump.

It may be possible to employ a configuration in which the photonic crystal-surface emitting laser includes first and second electrodes provided on a side of the laser driver and used to energize the light-emitting element, the first electrode is electrically coupled to the laser driver through a first bump, and the second electrode is electrically coupled to the laser driver through a second bump.

It may be possible to employ a configuration in which the photonic crystal-surface emitting laser includes a pedestal provided alongside the light-emitting element in an in-plane direction, the first electrode is provided on a surface of the light-emitting element that is disposed on a side of the laser driver, and the second electrode is provided on a surface of the pedestal that is disposed on a side of the laser driver.

It may be possible to employ a configuration in which the photonic crystal-surface emitting laser includes: a substrate on which the light-emitting element and the pedestal are provided in a protruding manner; and a wiring coupled to the second electrode and extending along the pedestal from a side of the second electrode to a side of the substrate.

The photonic crystal-surface emitting laser may include an intermediate electrode directly or indirectly provided on the substrate and coupled to the wiring.

The photonic crystal-surface emitting laser may include a low-resistance layer provided closer to the substrate than the active layer and the photonic crystal layer, and the low-resistance layer may have a lower resistance than the substrate.

It may be possible to employ a configuration in which the substrate includes a semiconductor substrate, and the low-resistance layer includes a tunnel junction layer.

The low-resistance layer may include a current spreading layer.

The first and second electrodes may be provided on a surface of the light-emitting element that is on a side of the laser driver.

It may be possible to employ a configuration in which the photonic crystal-surface emitting laser includes: a substrate on which the light-emitting element is provided in a protruding manner; and a wiring coupled to the second electrode and extending along the light-emitting element from a side of the second electrode to a side of the substrate.

The photonic crystal-surface emitting laser may include an intermediate electrode directly or indirectly provided on the substrate and coupled to the wiring.

The photonic crystal-surface emitting laser may include a low-resistance layer provided closer to the substrate than the active layer and the photonic crystal layer, and the low-resistance layer has a lower resistance than the substrate.

It may be possible to employ a configuration in which the substrate includes a semiconductor substrate, and the low-resistance layer includes a tunnel junction layer.

It may be possible to employ a configuration in which the substrate includes a semi-insulating substrate or an insulating substrate, and the low-resistance layer includes a current spreading layer.

The laser driver may include a switching element coupled to either one of the first and second electrodes.

It may be possible to employ a configuration in which the photonic crystal-surface emitting laser includes a plurality of the light-emitting elements arrayed in an in-plane direction, the laser driver includes a plurality of switching elements corresponding to the plurality of light-emitting elements, and each of the plurality of switching elements is coupled to either one of the first and second electrodes used to energize a corresponding light-emitting element.

The photonic crystal-surface emitting laser may include a current confining layer.

The photonic crystal-surface emitting laser may include a reflecting mirror provided on an opposite side of the active layer and the photonic crystal layer from an outputting side of the photonic crystal-surface emitting laser.

The light-emitting element may include a small diameter portion on a side of the laser driver or on an opposite side from the side of the laser driver.

### Brief Description of the Drawings

[FIG. 1] FIG. 1 is a cross-sectional view of a light source apparatus according to a First Example of one embodiment of the present technology.
[FIG. 2] FIG. 2 is a schematic plan view of the light source apparatus according to the First Example of one embodiment of the present technology.
[FIG. 3] FIG. 3 is a flowchart used to describe one example of a method of manufacturing a light source apparatus in FIG. 1.
[FIG. 4] FIG. 4 is a cross-sectional view concerning each step of one example of the method of manufacturing a light source apparatus in FIG. 1.
[FIG. 5] FIG. 5 is a cross-sectional view concerning each step of one example of the method of manufacturing a light source apparatus in FIG. 1.
[FIG. 6] FIG. 6 is a cross-sectional view concerning each step of one example of the method of manufacturing a light source apparatus in FIG. 1.
[FIG. 7] FIG. 7 is a cross-sectional view concerning each step of one example of the method of manufacturing a light source apparatus in FIG. 1.
[FIG. 8] FIG. 8 is a cross-sectional view concerning each step of one example of the method of manufacturing a light source apparatus in FIG. 1.
[FIG. 9] FIG. 9 is a cross-sectional view concerning each step of one example of the method of manufacturing a light source apparatus in FIG. 1.
[FIG. 10] FIG. 10 is a cross-sectional view concerning each step of one example of the method of manufacturing a light source apparatus in FIG. 1.
[FIG. 11] FIG. 11 is a cross-sectional view concerning each step of one example of the method of manufacturing a light source apparatus in FIG. 1.
[FIG. 12] FIG. 12 is a cross-sectional view concerning each step of one example of the method of manufacturing a light source apparatus in FIG. 1.
[FIG. 13] FIG. 13 is a cross-sectional view concerning each step of one example of the method of manufacturing a light source apparatus in FIG. 1.
[FIG. 14] FIG. 14 is a cross-sectional view concerning each step of one example of the method of manufacturing a light source apparatus in FIG. 1.
[FIG. 15] FIG. 15 is a cross-sectional view concerning each step of one example of the method of manufacturing a light source apparatus in FIG. 1.
[FIG. 16] FIG. 16 is a cross-sectional view concerning each step of one example of the method of manufacturing a light source apparatus in FIG. 1.
[FIG. 17] FIG. 17 is a cross-sectional view concerning each step of one example of the method of manufacturing a light source apparatus in FIG. 1.
[FIG. 18] FIG. 18 is a cross-sectional view of a light source apparatus according to a Second Example of one embodiment of the present technology.
[FIG. 19] FIG. 19 is a cross-sectional view of a light source apparatus according to a Third Example of one embodiment of the present technology.
[FIG. 20] FIG. 20 is a cross-sectional view of a light source apparatus according to a Fourth Example of one embodiment of the present technology.
[FIG. 21] FIG. 21 is a cross-sectional view of a light source apparatus according to a Fifth Example of one embodiment of the present technology.
[FIG. 22] FIG. 22 is a schematic plan view of the light source apparatus according to the Fifth Example of one embodiment of the present technology.
[FIG. 23] FIG. 23 is a cross-sectional view of a light source apparatus according to a Sixth Example of one embodiment of the present technology.
[FIG. 24] FIG. 24 is a cross-sectional view of a light source apparatus according to a Seventh Example of one embodiment of the present technology.
[FIG. 25] FIG. 25 is a cross-sectional view of a light source apparatus according to an Eighth Example of one embodiment of the present technology.
[FIG. 26] FIG. 26 is a cross-sectional view of a light source apparatus according to a Ninth Example of one embodiment of the present technology.
[FIG. 27] FIG. 27 is a cross-sectional view of a light source apparatus according to a Tenth Example of one embodiment of the present technology.
[FIG. 28] FIG. 28 is a cross-sectional view of a light source apparatus according to an Eleventh Example of one embodiment of the present technology.
[FIG. 29] FIG. 29 is a cross-sectional view of a light source apparatus according to a Twelfth Example of one embodiment of the present technology.
[FIG. 30] FIG. 30 is a cross-sectional view of a light source apparatus according to a Thirteenth Example of one embodiment of the present technology.
[FIG. 31] FIG. 31 is a cross-sectional view of a light source apparatus according to a Fourteenth Example of one embodiment of the present technology.
[FIG. 32] FIG. 32 is a diagram illustrating an example in which the light source apparatus in FIG. 1 is applied to a distance measuring apparatus.
[FIG. 33] FIG. 33 is a block diagram illustrating one example of the schematic configuration of a vehicle control system.
[FIG. 34] FIG. 34 is an explanatory view of one example of positions where the distance measuring apparatus is installed.

### Modes for Carrying Out the Invention

Below, preferred embodiment according to the present technology will be described in detail with reference to the attached drawings. Note that, in the present description and the drawings, the same reference characters are attached to constituent elements having substantially the same functional configurations, and redundant explanation thereof will not be repeated. The embodiments described below are provided as typical embodiments according to the present technology, and should not be interpreted so that the description of the embodiment narrows the scope of the present technology. In the present description, even when the light source apparatus according to the present technology is described as providing a plurality of effects, it is only necessary that the light source apparatus according to the present technology provides at least one effect. The effects described in the present description are given as examples, and are not given for the purpose of limitation. In addition, it is possible to provide other effects.

In addition, description will be made in the following order.
0. Introduction
1. Light source apparatus according to the First Example of one embodiment of the present technology
2. Light source apparatus according to the Second Example of one embodiment of the present technology
3. Light source apparatus according to the Third Example of one embodiment of the present technology
4. Light source apparatus according to the Fourth Example of one embodiment of the present technology
5. Light source apparatus according to the Fifth Example of one embodiment of the present technology
6. Light source apparatus according to the Sixth Example of one embodiment of the present technology
7. Light source apparatus according to the Seventh Example of one embodiment of the present technology
8. Light source apparatus according to the Eighth Example of one embodiment of the present technology
9. Light source apparatus according to the Ninth Example of one embodiment of the present technology
10. Light source apparatus according to the Tenth Example of one embodiment of the present technology
11. Light source apparatus according to the Eleventh Example of one embodiment of the present technology
12. Light source apparatus according to the Twelfth Example of one embodiment of the present technology
13. Light source apparatus according to the Thirteenth Example of one embodiment of the present technology
14. Light source apparatus according to the Fourteenth Example of one embodiment of the present technology
15. Modification example according to the present technology
16. Application example to electronic apparatus
17. Example in which the light source apparatus is applied to a distance measuring apparatus
18. Example in which the distance measuring apparatus is mounted on a movable body

### <0. Introduction>

Semiconductor lasers are known to be useful as a light source in a range finder using a TOF (Time Of Flight) method or a light source module (light source apparatus) of the range finder. In order to achieve practical use of this, it is demanded to further reduce the size of the device and drive the semiconductor layer at a faster speed by considering both the cost and the performance.

In recent years, a photonic crystal-surface emitting laser (PCSEL), which is one type of the semiconductor laser, has been attracting attention. The photonic crystal-surface emitting laser makes it possible to obtain significantly narrowed light directly from a semiconductor structure, and emit coherent light with a large area, which are effects that other semiconductor lasers including existing surface emitting layer (for example, VCSEL) do not produce.

From the viewpoint of application of the apparatus for the purpose of miniaturization and high-speed driving of the light source module, it is desired to bond the photonic crystal-surface emitting laser directly to the laser driver. With direct bonding, it is possible to reduce the size of the module, and also reduce the inductance to operate at a high speed. Thus, from the viewpoint of application to the light source module, it is necessary to directly mount the PCSEL to the laser driver and to provide a wiring suitable for this direct mounting.

For this reason, the present inventors have executed trial and errors on the layer configuration of the PCSEL in order to directly bond the PCSEL to the laser driver and also on an electrical coupling method. Then, the present inventors have reached the light source apparatus according to the present technology as a light source apparatus in which the PCSEL is mounted directly at the laser driver. The present inventors have made further study, and have developed the light source apparatus according to one embodiment as a mode suitable for practical use of the light source apparatus according to the present technology.

Below, the light source apparatus according to one embodiment of the present technology will be described in detail by using several Examples as examples.

### <1. Light source apparatus according to the First Example of one embodiment of the present technology>

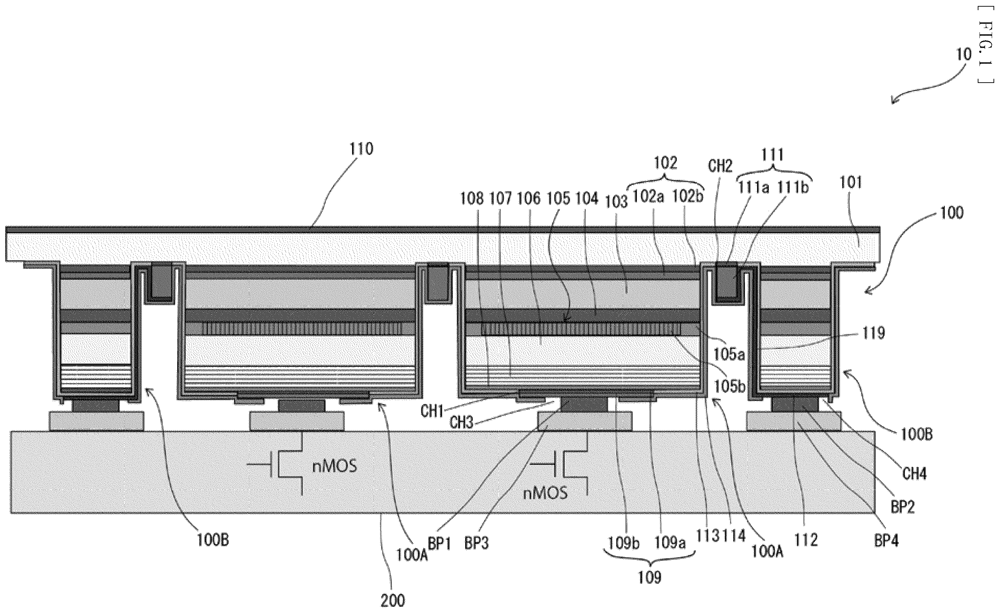

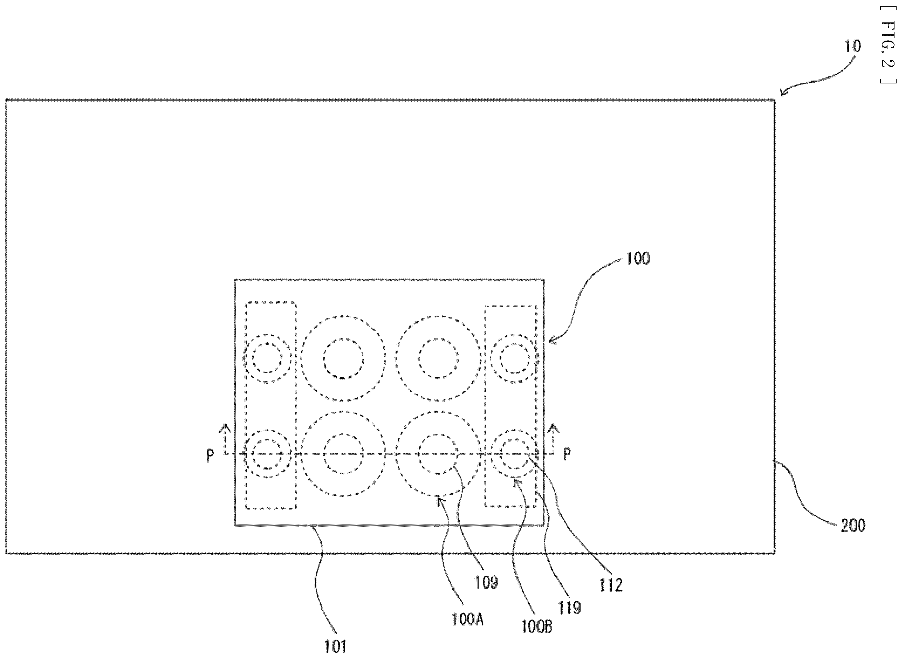

FIG. 1 is a cross-sectional view of a light source apparatus 10 according to the First Example of one embodiment of the present technology. FIG. 2 is a schematic plan view of the light source apparatus 10. FIG. 1 is a cross-sectional view taken along the line P-P in FIG. 2.

### <<Configuration of Light Source Apparatus>>

The light source apparatus 10 according to the First Example of one embodiment of the present technology includes a photonic crystal-surface emitting laser 100 and a laser driver 200 as illustrated in FIG. 1, as one example. The photonic crystal-surface emitting laser is also referred to as a "PCSEL."

The photonic crystal-surface emitting laser 100 is a surface emitting laser mounted at the laser driver 200 in a flip chip manner. That is, the photonic crystal-surface emitting laser 100 is mounted at the laser driver 200 in a junction-down manner.

The photonic crystal-surface emitting laser 100 includes a plurality (four pieces) of light-emitting elements 100A in which a plurality of layers including an active layer 104 and a photonic crystal layer 105 is stacked in a layering direction, as one example (see FIG. 2). The plurality of light-emitting elements 100A is arrayed in an in-plane direction, and as one example, is arrayed in an in-plane direction in a two-dimensional manner. Specifically, the plurality of light-emitting elements 100A is arrayed in a matrix manner at equal intervals in row and column directions, as one example. The active layer 104 and the photonic crystal layer 105 are disposed alongside each other in a layering direction as one example. Specifically, the active layer 104 and the photonic crystal layer 105 are disposed alongside each other such that the photonic crystal layer 105 is disposed at the laser driver 200 side. Note that the active layer 104 and the photonic crystal layer 105 may be disposed alongside each other in the layering direction such that the active layer 104 is disposed at the laser driver 200 side.

The plurality of light-emitting elements 100A is able to vary the FOV (visual field angle) of the output light or the like so as to differ from each other, for example.

The photonic crystal-surface emitting laser 100 further includes a pedestal 100B aligned with (disposed alongside, for example) the light-emitting element 100A in an in-plane direction (direction perpendicular to the layering direction), as one example. The light-emitting element 100A and the pedestal 100B each have a mesa shape, as one example. The light-emitting element 100A is also referred to as a "light emission mesa" because it emits light and has a mesa shape. The pedestal 100B is also referred to as a "dummy mesa" because it has a mesa shape but it does not emit light.

The photonic crystal-surface emitting laser 100 further includes first and second insulation films 113 and 114 serving as protecting films that cover the light-emitting element 100A and the pedestal 100B, as one example. The first insulation film 113 is an insulation film disposed at the inner side and directly covering a semiconductor structure of the light-emitting element 100A. The second insulation film 114 is an insulation film disposed at the outer side and covering the semiconductor structure of the light-emitting element 100A with the first insulation film 113 being interposed between the second insulation film 114 and the semiconductor structure.

The photonic crystal-surface emitting laser 100 further includes a substrate 101 as one example. On the substrate 101, the plurality of light-emitting elements 100A and the pedestal 100B are provided in a protruding manner at a surface of the substrate that is at the laser driver 200 side. The substrate 101 is shared among the plurality of light-emitting elements 100A. The substrate 101 is disposed at an opposite side from the laser driver 200 side with respect to the active layer 104 and the photonic crystal layer 105, as one example. The photonic crystal-surface emitting laser 100 is a surface emitting laser disposed at a back-illuminated side and configured to emit laser light toward the back side (an opposite side from the laser driver 200 side) of the substrate 101. An AR (Anti-reflection) film 110 is provided on the back surface of the substrate 101.

The laser driver 200 is electrically coupled to the photonic crystal-surface emitting laser 100 through a bump, as one example. That is, the laser driver 200 is electrically and mechanically coupled to the photonic crystal-surface emitting laser 100, as one example.

The photonic crystal-surface emitting laser 100 includes first and second electrodes 109 and 112 provided on the laser driver 200 side and used to energize the light-emitting element 100A, as one example. The first electrode 109 is electrically coupled to the laser driver 200 through a first bump BP1, as one example. The second electrode 112 is electrically coupled to the laser driver 200 through a second bump BP2. The laser driver 200 includes a third bump BP3 bonded to the first bump BP1 and also includes a fourth bump BP4 bonded to the second bump BP2, as one example. The first to fourth bumps BP1 to BP4 are bumps each having electrical conductivity.

The laser driver 200 includes a power supply and a MOSFET (Metal-Oxide-Semiconductor Field-effect Transistor) serving as a switching element coupled to either one of the first and second electrodes 109 and 112 (for example, to the first electrode 109), as one example. Here, the laser driver 200 includes a plurality of switching elements that correspond to the plurality of light-emitting elements 100A. Each of the plurality of switching elements is coupled to either one of the first and second electrodes 109 and 112 (for example, to the first electrode 109) used to energize the corresponding light-emitting element 100A. The laser driver 200 includes a circuit element such as a capacitor, a resistance, or the like, in addition to the power supply and the plurality of switching elements.

An n-type MOSFET (hereinafter, referred to as an "nMOS") is used as the MOSFET, as one example. The nMOS is provided within a p-type semiconductor substrate (p-type silicon substrate, for example), as one example. The nMOS includes a drain coupled to the third bump BP3 as one example, and also includes a source coupled to the cathode side of the power supply, thereby being configured such that a gate voltage is applied to the gate. The fourth bump BP4 is coupled to the anode side of the power supply. The nMOS generates a drive pulse used to emit light and turn out the light of the light-emitting element 100A, and applies it to the light-emitting element 100A. In particular, by using the nMOS for the switching element, it is possible to reduce the size of the switching element, which leads to an improvement in the miniaturization of and the degree of freedom in design of the laser driver 200.

The first electrode 109 is provided on a surface of the light-emitting element 100A that is disposed at the laser driver 200 side, as one example. The second electrode 112 is provided on a surface of the pedestal 100B that is disposed at the laser driver 200 side, as one example. The first electrode 109 serves as a cathode electrode, and the second electrode 112 serves as an anode electrode, as one example.

The photonic crystal-surface emitting laser 100 includes a wiring 119 coupled to the second electrode 112 and extending along the pedestal 100B from the second electrode 112 side to the substrate 101 side, as one example. The wiring 119 is at least provided on the side surface of the pedestal 100B.

The photonic crystal-surface emitting laser 100 includes an intermediate electrode 111 directly or indirectly (for example, directly) provided on the substrate 101 and coupled to the wiring 119, as one example.

The photonic crystal-surface emitting laser 100 includes a tunnel junction layer 102 serving as a low-resistance layer provided on the substrate 101 side of the active layer 104 and the photonic crystal layer 105 and having a lower resistance than the substrate 101, as one example.

The photonic crystal-surface emitting laser 100 includes a first clad layer 103 between the tunnel junction layer 102 and the active layer 104, as one example.

The photonic crystal-surface emitting laser 100 includes a reflecting mirror 107 provided on the laser driver 200 side with respect to the active layer 104 and the photonic crystal layer 105, as one example.

The photonic crystal-surface emitting laser 100 includes a second clad layer 106 provided between the photonic crystal layer 105 and the reflecting mirror 107, as one example.

The photonic crystal-surface emitting laser 100 includes a contact layer 108 provided on the reflecting mirror 107 and on the opposite side from the active layer 104 side and the photonic crystal layer 105 side, as one example.

As can be understood from the description above, the photonic crystal-surface emitting laser 100 has a stacked structure in which the tunnel junction layer 102, the first clad layer 103, the active layer 104, the photonic crystal layer 105, the second clad layer 106, the reflecting mirror 107, and the contact layer 108 are stacked in this order at the substrate 101 in the layering direction, as one example.

### (Substrate)

The substrate 101 includes a semiconductor substrate configured to be transparent for the emission wavelength of the light-emitting element 100A and having electrical conductivity in an in-plane direction, as one example. The substrate 101 includes a first conductivity-type (for example, an n-type) semiconductor substrate (for example, an n-GaAs substrate), as one example.

### (AR Film)

The AR film 110 has a stacked structure in which a plurality of dielectric films (for example, a SiO2 film, a SiN film, a SiON film, and the like) is stacked, as one example.

### (Tunnel junction layer)

The tunnel junction layer 102 is a layer used to invert carriers of a current. The tunnel junction layer 102 is provided so as to come into contact with a surface of the substrate 101 that is disposed at the side of the active layer 104 and the photonic crystal layer 105, as one example. The tunnel junction layer 102 includes a p-type semiconductor layer 102a and an n-type semiconductor layer 102b disposed so as to be in contact with each other in a layering direction, as one example. The tunnel junction layer 102 is stacked at the substrate 101 such that the n-type semiconductor layer 102b is disposed at the substrate 101 side. The p-type semiconductor layer 102a includes high-dope p-GaAs, for example. The n-type semiconductor layer 102b includes high-dope n-GaAs, for example.

### (First clad layer)

The first clad layer 103 includes a first conductivity-type (for example, a p-type) Alx1Ga1-x1As (0 ≦ x1 < 1)-based compound semiconductor, as one example. The clad layer is also referred to as a "spacer layer." The first clad layer 103 includes p-type impurities such as carbon (C), for example.

### (Active layer)

The active layer 104 has a quantum well structure including a barrier wall layer including a GaAs-based compound semiconductor and a well layer, as one example. Specifically, the active layer 104 has a multi quantum well structure (MQW structure) in which a well layer including undoped Inx6Ga1-x6As (0 < x6 < 1) and a barrier wall layer including undoped Inx1Ga1-x1As (0 < x1 < x6) are alternately stacked, for example. The quantum well structure may include a signal quantum well structure (QW structure). The emission wavelength λ of the active layer 104 is 935 nm, for example. The active layer is also referred to as a "light-emitting layer."

### (Photonic crystal layer)

The photonic crystal layer 105 imparts resonating and diffracting effects by photonic crystal to the light emitted from the active layer 104 disposed adjacent in the layering direction.

The photonic crystal layer 105 is configured such that a different-refractive-index region 105b differing from a sheet-like base member 105a is disposed periodically (for example, in a lattice form) at the base member 105a, as one example. The photonic crystal layer 105 is configured such that the cycle (for example, intervals between lattice points) of the different-refractive-index region 105b is the same as the emission wavelength λ of the active layer 104, as one example. The material of the base member 105a includes GaAs, for example. However, the material is not limited to this. The different-refractive-index region 105b includes a hole (air or vacuum), for example, and is provided at a position corresponding to a light-emitting region (for example, a central portion) of the active layer 104.

Since the cyclic distribution of the index of refraction as described above exists within the photonic crystal layer 105, light having a specific wavelength (for example, the emission wavelength λ) forms a two-dimensional standing-wave state in a specific direction in the photonic crystal surface. In the photonic crystal layer 105, diffraction occurs not only in a direction parallel to the photonic crystal surface but also in a perpendicular direction. This enables a beam having a narrow output angle to be outputted toward a direction (layering direction) perpendicular to the in-plane direction. Thus, it is possible to obtain a surface emission output.

### (Second clad layer)

The second clad layer 106 includes a second conductivity-type (for example, an n-type) Alx2Ga1-x2As (0 ≦ x2 < 1)-based compound semiconductor, as one example. The clad layer is also referred to as a "spacer layer." The second clad layer 106 includes n-type impurities such as phosphorus (P), for example.

### (Reflecting mirror)

Light emitted from the active layer 104 and outputted to the opposite side from the substrate 101 side through the photonic crystal layer 105 is reflected by the reflecting mirror 107 toward the photonic crystal layer 105 side. The reflecting mirror 107 is provided in this manner to enhance the light utilization efficiency. Since the reflecting mirror 107 is provided for the purpose of increasing the efficiency as described above, the reflecting mirror 107 is not essential element.

The reflecting mirror 107 includes a semiconductor multi-layer-film reflecting mirror, as one example. The multi-layer-film reflecting mirror is also referred to as a distribution-type Bragg reflecting mirror (Distributed Bragg Reflector). Specifically, the reflecting mirror 107 includes the first conductivity-type (for example, an n-type) semiconductor multi-layer-film reflecting mirror as one example, and has a structure in which a plurality of types (for example, two types) of semiconductor layers having different indexes of refraction is alternately stacked with an optical thickness of quarter wavelength of the emission wavelength. Refractive index layers of the reflecting mirror 107 each include a first conductivity-type (for example, an n-type) AlGaAs-based compound semiconductor. Specifically, the reflecting mirror 107 includes a low refractive index layer including, for example, n-Alx3Ga1-x3As (0 < x3 < 1), and also includes a high refractive index layer including, for example, n-Alx4Ga1-X4As (0 ≦ x4 < x3).

### (Contact layer)

The contact layer 108 includes a layer used to bring the reflecting mirror 107 and the first electrode 109 into ohmic contact with each other. The contact layer 108 includes n-Alx5Ga1-x5As (0 ≦ x5 < 1), for example.

The second clad layer 106, the reflecting mirror 107, and the contact layer 108 include n-type impurities such as silicon (Si), for example. That is, the second clad layer 106, the reflecting mirror 107, and the contact layer 108 are configured as an n- type semiconductor.

### (Insulation film)

The first and second insulation films 113 and 114 include a dielectric substance such as SiN, SiO2, or SiON, for example. In particular, in a case where the first and second insulation films 113 and 114 include SiN, these films contribute to suppressing moisture entering from the outside. The first insulation film 113 at the top portion of the light-emitting element 100A includes a first contact hole CH1 that causes the contact layer 108 to be exposed, the first contact hole CH1 being provided at a position corresponding to the light-emitting region of the active layer 104. The first insulation film 113 that covers a region between mesas includes a second contact hole CH2 that causes the substrate 101 to be exposed. The second insulation film 114 at the top portion of the light-emitting element 100A includes a third contact hole CH3 that causes the first electrode 109 to be exposed. The second insulation film 114 at the top portion of the pedestal 100B includes a fourth contact hole CH4 that causes the second electrode 112 to be exposed.

### (First electrode)

The first electrode 109 is disposed at a position of the active layer 104 that corresponds to the light-emitting region. The first electrode 109 is in contact with a portion of the contact layer 108 that corresponds to the light-emitting region of the active layer 104. Thus, the first electrode 109 is electrically coupled to the reflecting mirror 107 through the contact layer 108. The first electrode 109 includes alloy as one example. Specifically, the first electrode 109 includes a stacked body in which a first contact electrode 109a and a first pad electrode 109b are stacked in this order from the contact layer 108 side. The first contact electrode 109a is provided so as to be in contact with the contact layer 108 in the first contact hole CH1. The first contact electrode 109a has a stacked structure in which an AuGe layer, a Ni layer, and an Au layer are stacked in this order from the contact layer 108 side. The first pad electrode 109b is exposed to the outside through the third contact hole CH3. The first pad electrode 109b has a stacked structure in which non-alloy metal films such as a Ti layer, a Pt layer, or an Au layer are stacked in this order from the contact layer 108 side, as one example.

The first electrode 109 is coupled to the drain of the nMOS of the laser driver 200 through the first and third bumps BP1 and BP3.

### (Second electrode)

The second electrode 112 has a stacked structure in which non-alloy metal films such as a Ti layer, a Pt layer, or an Au layer are stacked in this order from the contact layer 108 side.

The second electrode 112 is coupled to the anode side of the power supply of the laser driver 200 through the second and fourth bumps BP2 and BP4.

### (Intermediate electrode)

The intermediate electrode 111 includes a stacked body in which a second contact electrode 111a and a second pad electrode 111b are stacked in this order from the substrate 101 side, as one example. The second contact electrode 111a is provided so as to be in contact with the substrate 101 in the second contact hole CH2. The second contact electrode 111a has a stacked structure in which AuGe, Ni, and Au are stacked in this order from the substrate 101 side, for example. The second pad electrode 111b includes, for example, a Ti layer, an Au layer, and the like provided on the second contact electrode 111a in a form of thick film, and contributes to reduction in the resistance of the intermediate electrode 111.

### (Wiring)

The wiring 119 couples the second electrode 112 and the intermediate electrode 111. Specifically, the wiring 119 is provided so as to extend over the side surface of and the top portion of the pedestal 100B and the side surface of and the top portion of the second pad electrode 111b of the intermediate electrode 111. The wiring 119 includes a Ti layer, an Au layer, and the like, for example. The wiring 119 is provided so as to be shared among a plurality of (for example, two) pedestals 100B, as one example (see FIG. 2).

### (Bump)

The first and second bumps BP1 and BP2 provided on the photonic crystal-surface emitting laser 100 are electrically conductive bumps having electrical conductivity, and include a metal such as Ag, Au, Cu, or Ni, for example. The third and fourth bumps BP3 and BP4 provided on the laser driver 200 are electrically conductive bumps having electrical conductivity, and include a Pb-free solder such as AgSn, AuSn, CuSn, NiSn, or CuNiSn, for example. The first and third bumps BP1 and BP3 are bonded through thermo-compression bonding, for example. The second and fourth bumps BP2 and BP4 are bonded through thermo-compression bonding, for example.

### <<Operation of Light Source Apparatus>>

Below, operation of the light source apparatus 10 will be described. In the light source apparatus 10, when the nMOS of the laser driver 200 turns on, a current from the power supply of the laser driver 200 flows into the intermediate electrode 111 through the fourth bump BP4, the second bump BP2, the second electrode 112 serving as the anode electrode, and the wiring 119 in this order. The current passing through the intermediate electrode 111 flows through in an in-plane direction within the substrate 101, and flows into the light-emitting element 100A. The current passing through the tunnel junction layer 102 and the first clad layer 103 of the light-emitting element 100A in this order is inputted into the active layer 104. At this time, the active layer 104 emits light. This light forms standing waves in an in-plane direction within the photonic crystal layer 105. Once the resonance conditions are met, the light is discharged from the photonic crystal layer 105 to the substrate 101 side and the opposite side from the substrate 101 side. The light discharged toward the substrate 101 side is directly outputted from the back surface of the substrate 101 as laser light. The light discharged toward the opposite side from the substrate 101 side is reflected by the reflecting mirror 107 toward the substrate 101 side, and is outputted from the back surface of the substrate 101 as laser light. The current passing through the active layer 104 passes through the photonic crystal layer 105, the second clad layer 106, the reflecting mirror 107, the contact layer 108, the first electrode 109 serving as the cathode electrode, the first bump BP1, and the third bump BP3 in this order, and flows out to the nMOS of the laser driver 200.

### <<Method of Manufacturing Light Source Apparatus>>

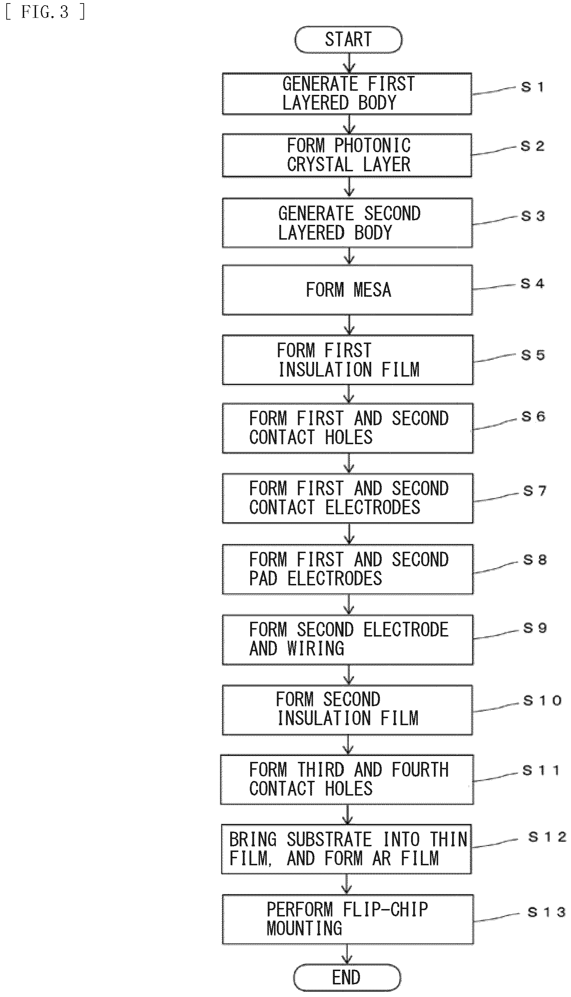

Below, a method of manufacturing the light source apparatus 10 will be described with reference to the flowchart of FIG. 3 or the like. The overall flow will be described. First, a method of manufacturing a semiconductor using a semiconductor manufacturing device is performed to generate, at the same time, a plurality of photonic crystal-surface emitting lasers 100 on one piece of wafer serving as a base member of the substrate 101 (hereinafter, this wafer is referred to as a "substrate 101" for the purpose of convenience). Next, the plurality of photonic crystal-surface emitting lasers 100 that are integrated in a series manner is separated from each other through dicing to obtain a chip-shaped photonic crystal-surface emitting laser 100. Finally, the photonic crystal-surface emitting laser 100 is mounted at the laser driver 200 in a flip-chip manner.

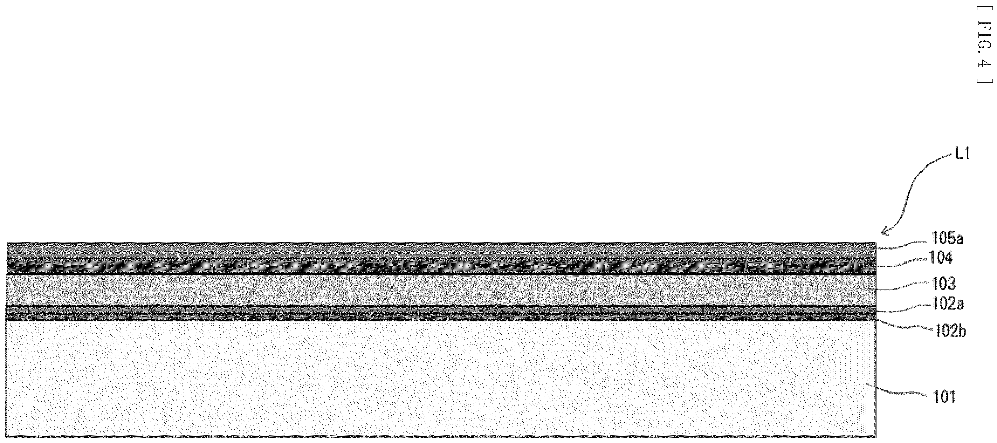

In first step S1, a first stacked body L1 is generated (see FIG. 4). Specifically, an epitaxial crystal growth method such as a MOCVD (Metal Organic Chemical Vapor Deposition) method is used to layer the n-type semiconductor layer 102b and the p-type semiconductor layer 102a of the tunnel junction layer 102, the first clad layer 103, the active layer 104, and the base member 105a of the photonic crystal layer 105 in this order at the substrate 101 (for example, an n-GaAs substrate) serving as a growth substrate. At this time, an arsine (AsH3) gas and a methyl-based organic metal gas such as trimethylaluminum (TMAl), trimethylgallium (TMGa), or trimethylindium (TMIn) are used as the raw material of the compound semiconductor, for example. In addition, disilane (Si2H6) is used as the raw material of donor impurities, for example. Furthermore, carbon tetrabromide (CBr4) is used as the raw material of acceptor impurities, for example.

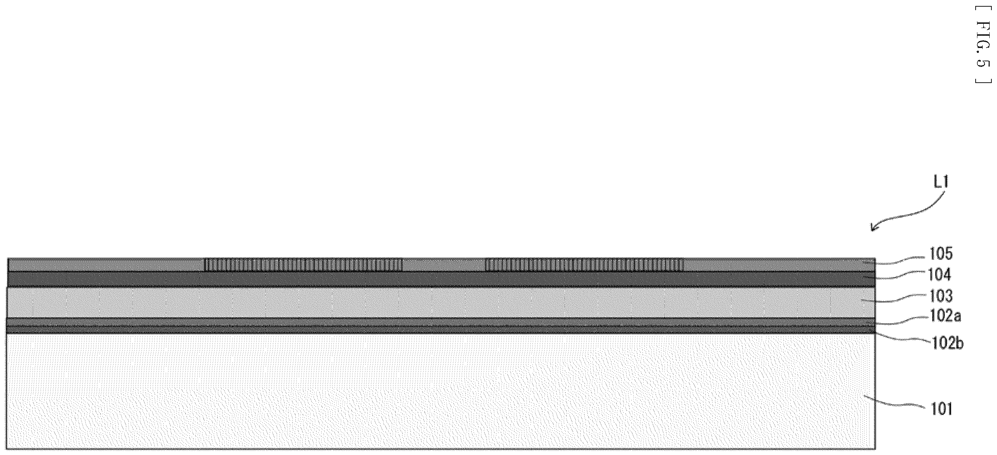

In next step S2, the photonic crystal layer 105 is formed (see FIG. 5). Specifically, a resist pattern used to form a different-refractive-index region 105b (a hole, for example) of the photonic crystal layer 105 is formed at the first stacked body L1 (at the base member 105a of the photonic crystal layer 105) through photolithography. Then, the base member 105a is selectively etched with the resist pattern being used as a mask. At this time, it is preferable to use RIE (Reactive Ion Etching) using a Cl-based gas, for example. After this, the resist pattern is removed.

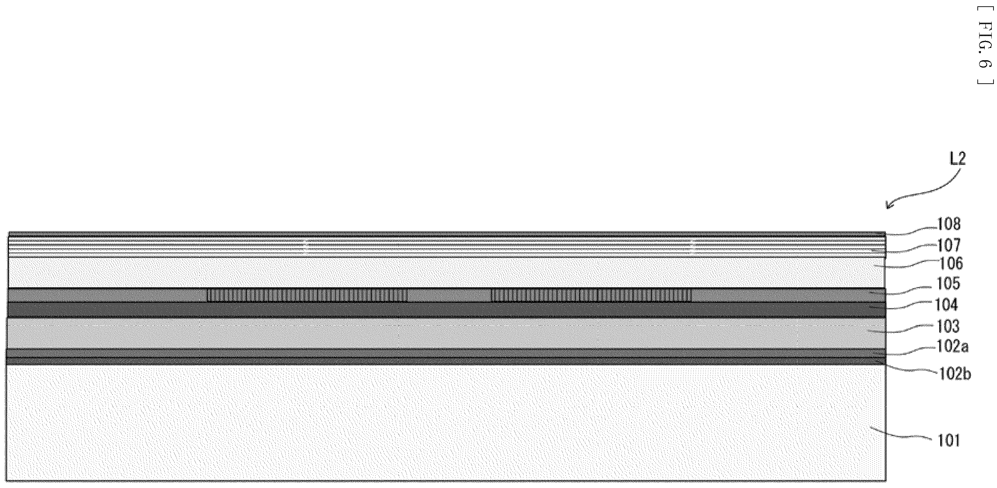

In next step S3, a second stacked body L2 is generated (see FIG. 6). Specifically, epitaxial growth is used again to layer the second clad layer 106, the reflecting mirror 107, and the contact layer 108 in this order at the first stacked body L1 in which the photonic crystal layer 105 is formed, and the second stacked body L2 in place of the first stacked body L1 is generated.

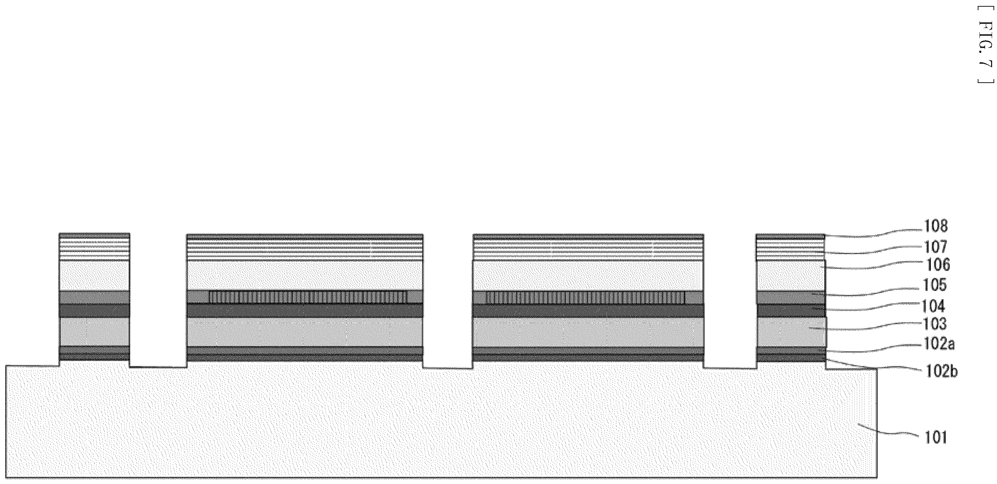

In next step S4, a mesa is formed (see FIG. 7). Specifically, a resist pattern used to form a mesa (light emission mesa) to be the light-emitting element 100A and a mesa (dummy mesa) to be the pedestal 100B is formed at the second stacked body L2 (see FIG. 6) through photolithography. Then, the second stacked body L2 is selectively etched through dry etching or wet etching with the resist pattern being used as a mask. Here, it is assumed that the depth of etching reaches the inside of the substrate 101, for example. After this, the resist pattern is removed.

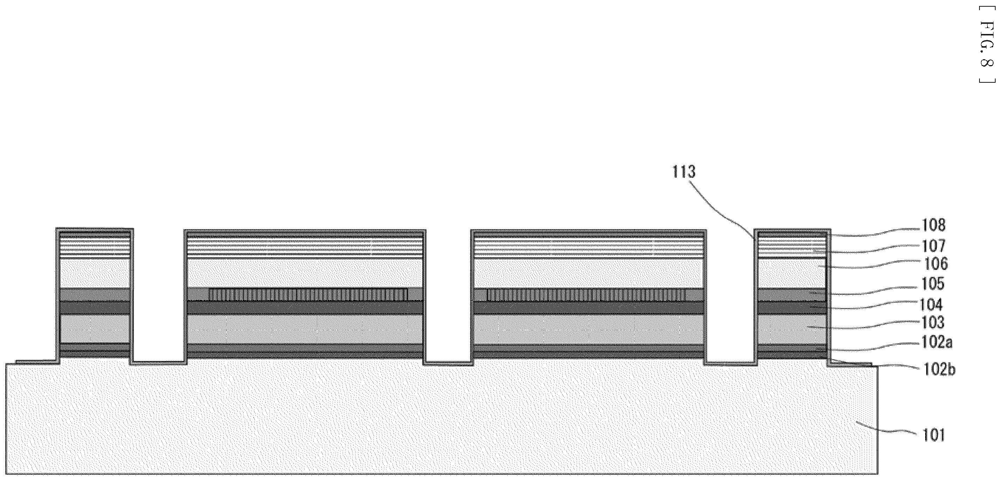

In next step S5, the first insulation film 113 is formed (see FIG. 8). Specifically, the first insulation film 113 is formed, for example, through CVD (Chemical Vapor Deposition), sputtering, deposition, or the like over the entire surface of the second stacked body L2 (see FIG. 7) where the mesas are formed.

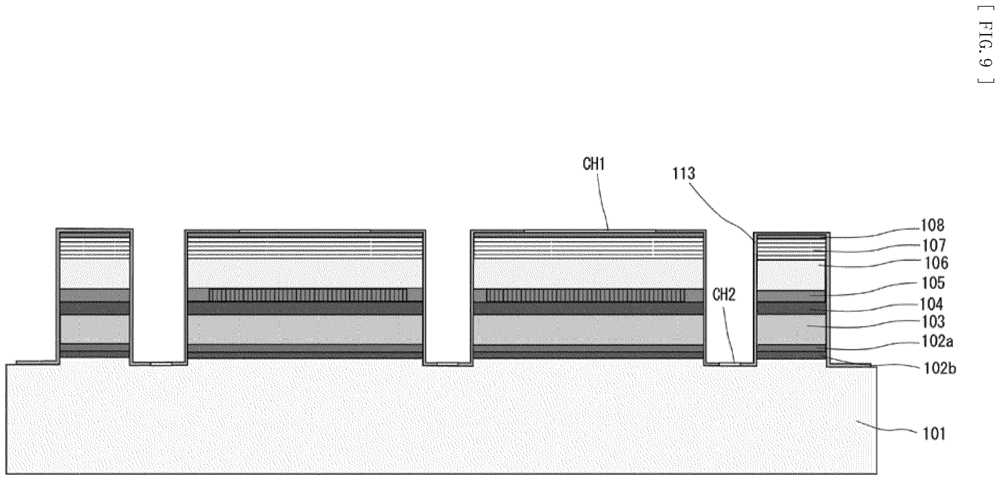

In next step S6, the first and second contact holes CH1 and CH2 are formed (see FIG. 9). Specifically, a resist pattern is formed at the first insulation film 113 through photolithography. The resist pattern is opened at a position where the first and second contact holes CH1 and CH2 are to be formed. Then, the first insulation film 113 is etched, for example, through dry etching with the resist pattern being used as a mask, to form the first and second contact holes CH1 and CH2. After this, the resist pattern is removed.

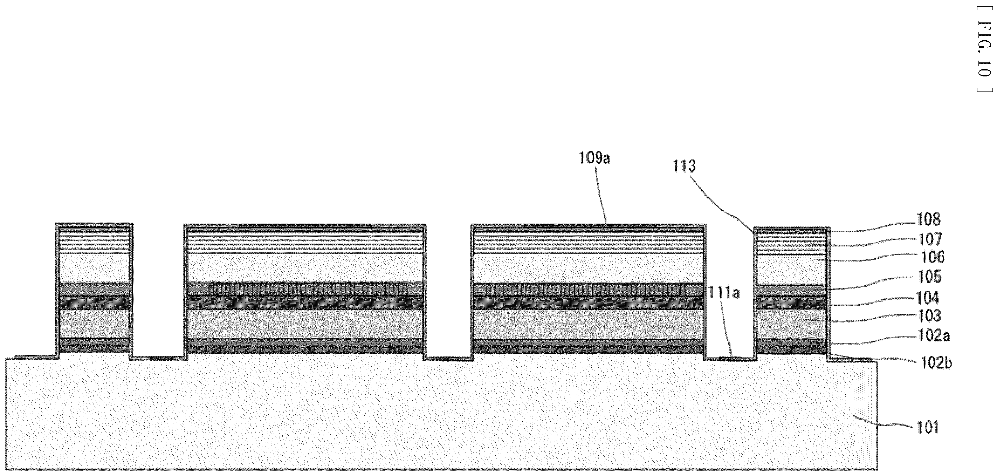

In next step S7, the first and second contact electrodes 109a and 111a are formed (see FIG. 10). Specifically, for example, through a lift-off method, the first contact electrode 109a is formed in the first contact hole CH1, and the second contact electrode 111a is formed in the second contact hole CH2. At this time, the film of the electrode material is formed using deposition, sputtering, or the like, for example.

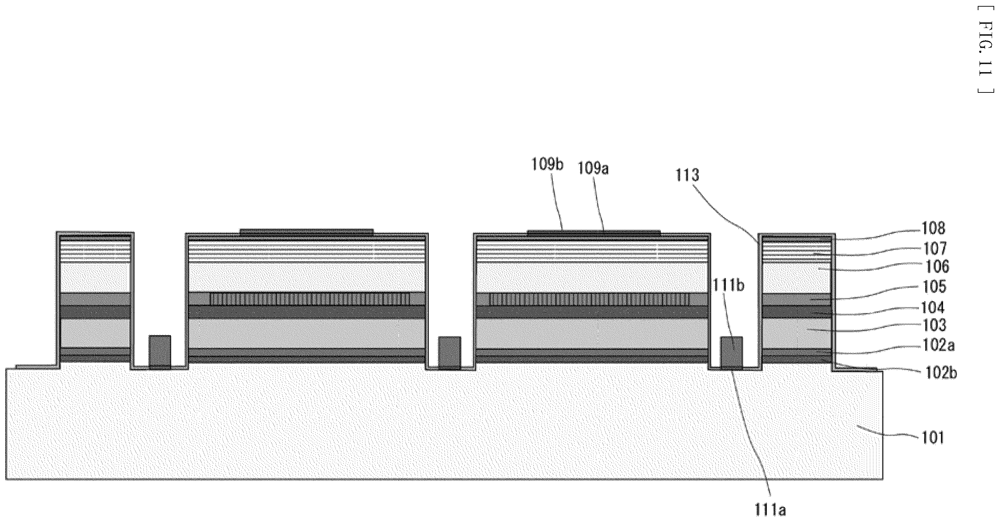

In next step S8, the first and second pad electrodes 109b and 111b are formed (see FIG. 11). Specifically, through a lift-off method, the first pad electrode 109b is formed at the first contact electrode 109a, and the second pad electrode 111b is formed at the second contact electrode 111a in a form of thick film (for example, approximately 2 µm so as to be able to sufficiently suppress a reduction in voltage), for example. At this time, the film of the electrode material is formed using deposition, sputtering, or the like, for example.

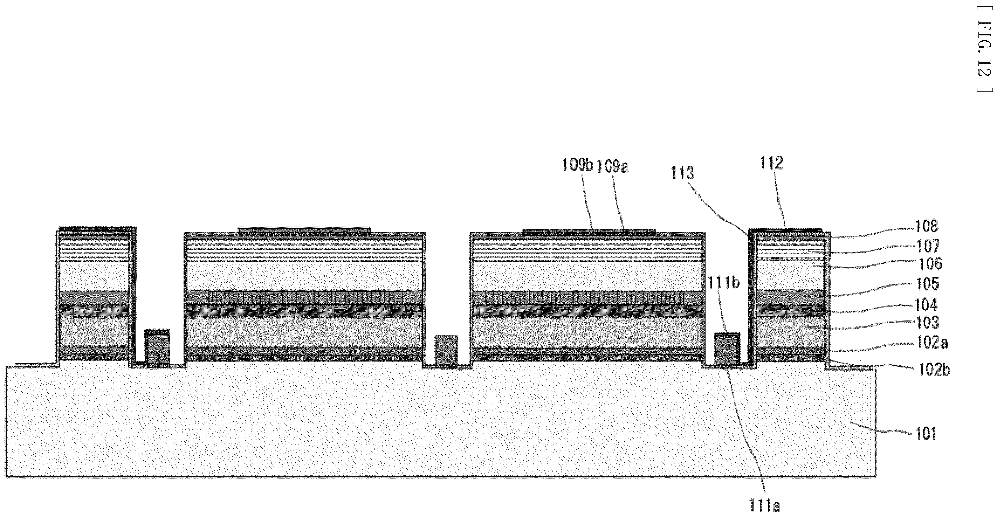

In next step S9, the second electrode 112 and the wiring 119 are formed (see FIG. 12). Specifically, for example, through a lift-off method, the second electrode 112 is formed at the top portion of the pedestal (dummy mesa), and the wiring 113 is formed at the side surface and the top portion of the pedestal and the side surface and the top portion of the second pad electrode 111b through deposition, plating, or the like, for example. With these processes, the second electrode 112 and the intermediate electrode 111 are electrically coupled to each other through the wiring 119.

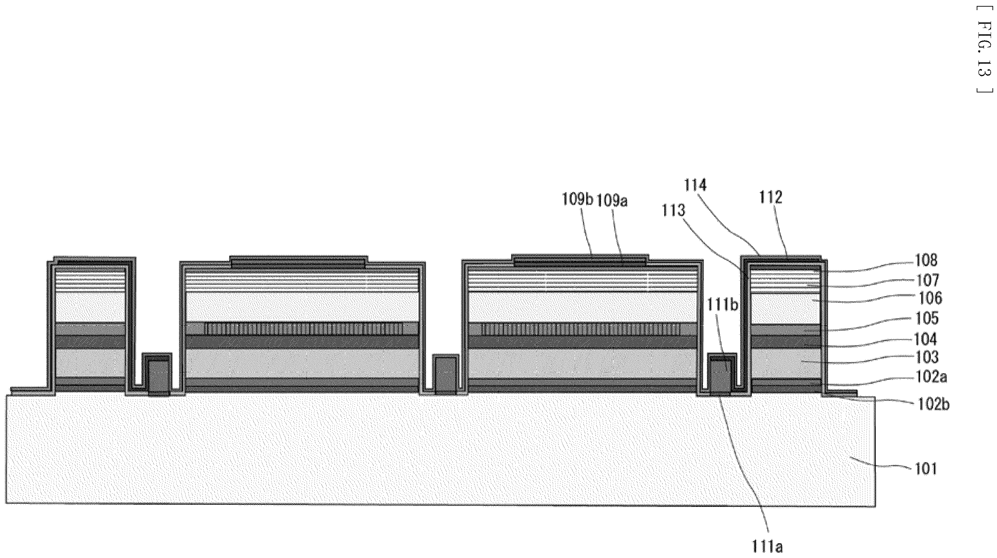

In next step S10, the second insulation film 114 is formed (see FIG. 13). Specifically, the second insulation film 114 is formed on the entire surface through deposition, sputtering, or the like, for example.

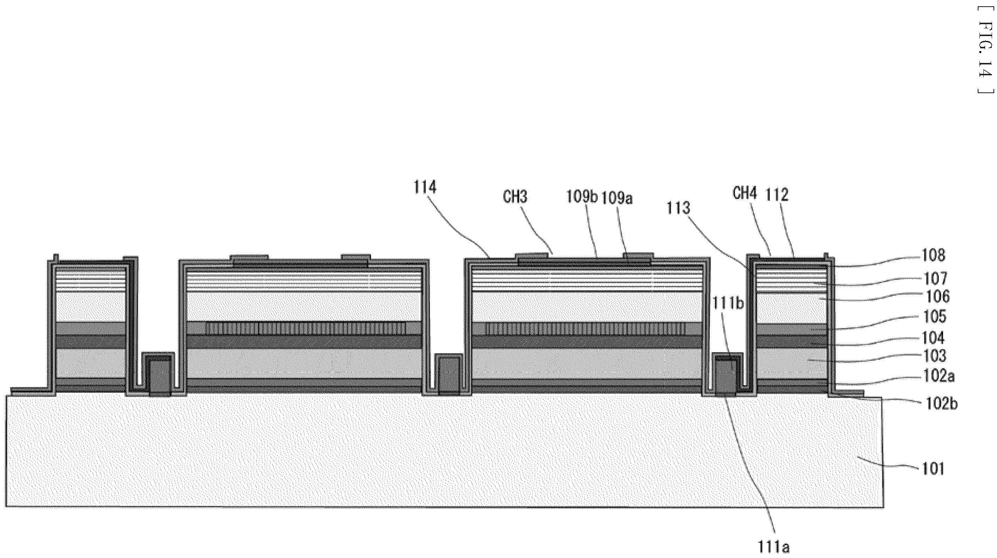

In next step S11, the third and fourth contact holes CH3 and CH4 are formed (see FIG. 14). Specifically, a resist pattern is formed at the second insulation film 114 through photolithography. The resist pattern is opened at a position where the third and fourth contact holes CH3 and CH4 are to be formed. Then, the first insulation film 114 is etched, for example, through dry etching with the resist pattern being used as a mask to form the third and fourth contact holes CH3 and CH4. After this, the resist pattern is removed.

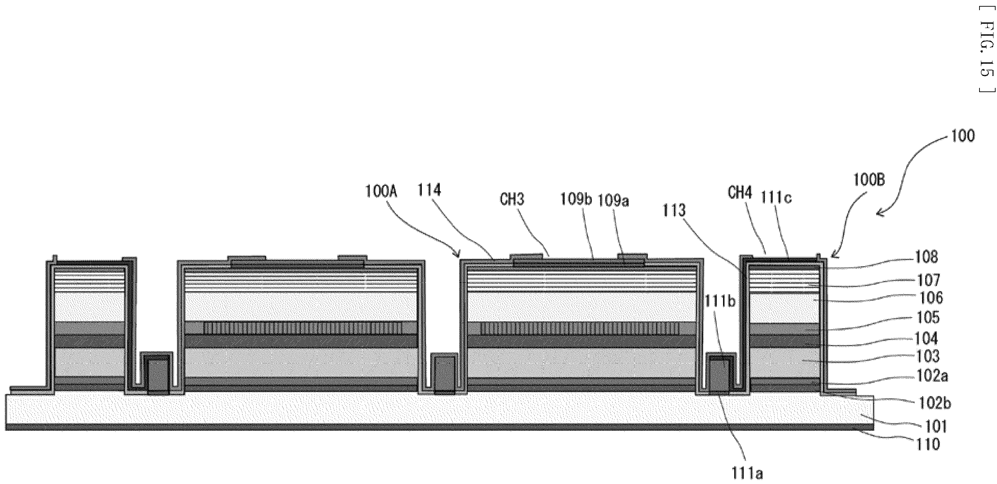

In next step S12, the substrate 101 is brought into a thin film to form the AR film 110 (see FIG. 15). Specifically, first, the back surface of the substrate 101 is cut using a grinder, a CMP (Chemical Mechanical Polisher) device or the like to bring it into a thin film. Next, the AR film 110 is formed, for example, through sputtering, deposition, or the like, at the back surface of the substrate 101 that has been brought into a thin film. After this, by dicing the substrate 101, it is possible to obtain a plurality of photonic crystal-surface emitting lasers 100 having a chip shape. Note that it is preferable that portions of the first and second insulation films 113 and 114 that are to be diced should be removed in advance before dicing.

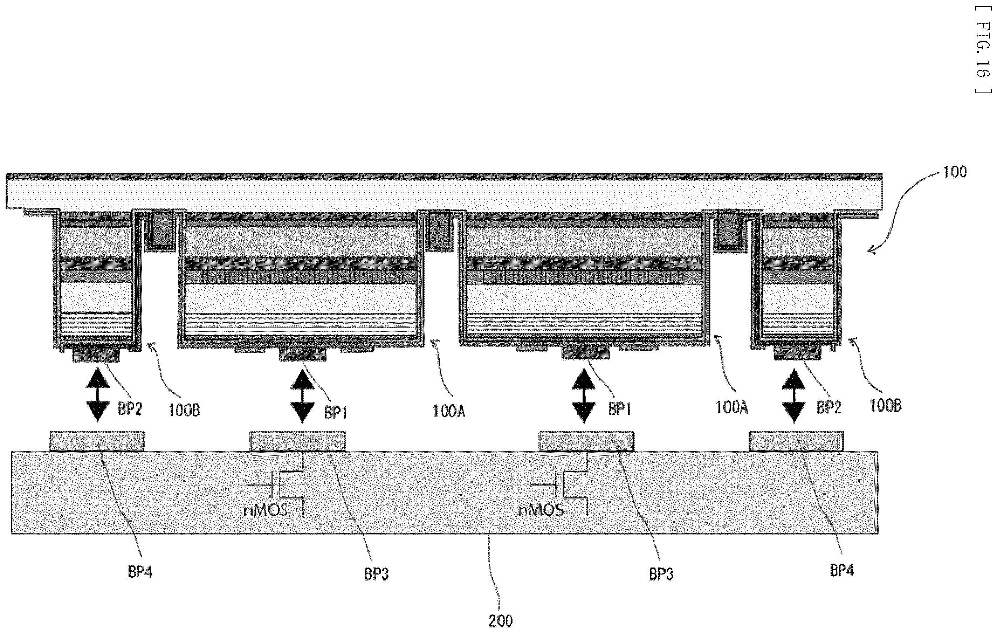

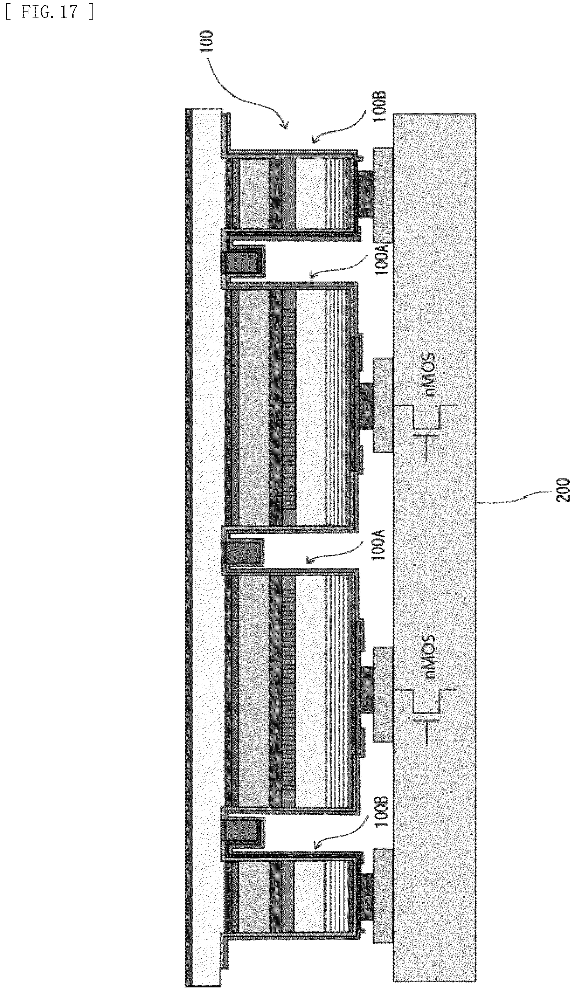

In final step S13, flip-chip mounting is performed (see FIGs. 16 and 17). Specifically, first, the first bump BP1 (for example, an Au bump) is attached to the light-emitting element 100A of the photonic crystal-surface emitting laser 100. In addition, the second bump BP2 (for example, an Au bump) is attached to the pedestal 100B. Furthermore, the third bump BP3 is attached at the position of the nMOS of the front surface of the laser driver 200. Moreover, the fourth bump BP4 is attached to the position of the anode side of the power supply at the front surface of the laser driver 200. Next, the photonic crystal-surface emitting laser 100 and the laser driver 200 are positioned to each other, and then, they are thermally bonded (bonded with pressure while they are being heated). Thus, the photonic crystal-surface emitting laser 100 and the laser driver 200 are electrically and mechanically coupled to each other through the bumps.

### <<Effects of Light Source Apparatus>>

Below, description will be made of effects of the light source apparatus 10 according to the First Example of one embodiment of the present technology. The light source apparatus 10 according to the First Example of one embodiment of the present technology includes the photonic crystal-surface emitting laser 100 (PCSEL) including at least one (for example, plural) light-emitting element 100A in which a plurality of layers including the active layer 104 and the photonic crystal layer 105 is stacked, and also includes the laser driver 200 electrically (directly) coupled to the photonic crystal-surface emitting laser 100 through the bump.

That is, in the light source apparatus 10, the photonic crystal-surface emitting laser 100 is mounted at the laser driver 200 in a junction-down manner (flip chip). In this case, it is possible to reduce the inductance and reduce the size, as compared with the light source apparatus in which the PCSEL is mounted at the laser driver in a junction-up manner using a wiring serving as a factor of the inductance. In addition, in a case of the light source apparatus 10 in which the PCSEL is mounted at the laser driver, it is possible to output a beam having a narrower output angle, as compared with the light source apparatus in which VCSEL is mounted at the laser driver, for example.

Thus, with the light source apparatus 10, it is possible to provide a light source apparatus that makes it possible to narrow the beam divergence of the output light and also reduce the size thereof and the inductance.

As a supplemental description, in the light source apparatus 10, the photonic crystal-surface emitting laser 100 and the laser driver 200 are bonded through the bump. Thus, it is possible to achieve a configuration in which factors of the resistance and impedance such as a wiring are removed. This makes it possible to reduce the resistance at the time of driving and also make it easy to input a very short electrical signal in the order of nanoseconds. Thus, it is possible to obtain the optical waveform having a significantly fast rising edge and falling edge. In particular, since the light-emitting element 100A is directly bonded to the nMOS, it is possible to achieve the fastest driving.

The photonic crystal-surface emitting laser 100 includes the first and second electrodes 109 and 112 provided on the laser driver 200 side and used to energize the light-emitting element 100A. In addition, the first electrode 109 is electrically coupled to the laser driver 200 through the first bump BP1, and the second electrode 112 is electrically coupled to the laser driver 200 through the second bump BP2. This configuration makes it possible to obtain a circuit used to cause a current to flow from the laser driver 200 to the photonic crystal-surface emitting laser 100.

The photonic crystal-surface emitting laser 100 includes the pedestal 100B provided alongside the light-emitting element 100A in an in-plane direction. In addition, the first electrode 109 is provided on a surface of the light-emitting element 100A, the surface being disposed at the laser driver 200 side. Furthermore, the second electrode 112 is provided on the surface of the pedestal 100B, the surface being disposed at the laser driver 200 side. This configuration makes it possible to dispose the first and second electrodes 109 and 112 so as to sandwich the light-emitting element 100A on the current path, and to be easily bonded directly to the laser driver 200.

The photonic crystal-surface emitting laser 100 includes: the substrate 101 on which the light-emitting element 100A and the pedestal 100B are provided in a protruding manner; and the wiring 119 coupled to the second electrode 112 and extending along the pedestal 100B from the second electrode 112 side to the substrate 101 side. This configuration makes it possible to cause the second electrode 112 and the substrate 101 side to electrically continuous with each other.

The photonic crystal-surface emitting laser 100 includes the intermediate electrode 111 directly or indirectly (for example, directly) provided on the substrate 101 and coupled to the wiring 119. The intermediate electrode 111 includes a material such as gold having high electrical conductivity, for example, and has a sufficiently thick thickness of 2 µm, for example. This makes it possible to reduce the electric resistance between the first and second electrodes 109 and 112.

The photonic crystal-surface emitting laser 100 includes a low-resistance layer provided on the substrate 101 side of the active layer 104 and the photonic crystal layer 105 and having a lower resistance than the substrate 101. This makes it possible to cause the electrical current to efficiently flow to the active layer 104.

The substrate 101 includes a semiconductor substrate (for example, an n-GaAs substrate), and the low-resistance layer includes the tunnel junction layer 102. This configuration makes it possible to cause a current passing through the second electrode 112, the wiring 119, and the intermediate electrode 111 in this order and to the substrate 101 to easily flow into the light-emitting element 100A. A supplemental description will be made. A current spreads toward the in-plane direction (lateral direction) in the semiconductor substrate serving as the substrate 101. Thus, it is possible to sufficiently and uniformly spread the current up to the central portion of the light-emitting element 100A having a width of several hundreds of µm, for example.

The laser driver 200 includes a switching element (for example, an nMOS) coupled to either one of the first and second electrodes 109 and 112 (for example, to the first electrode 109). This configuration makes it possible to control emitting or turning off the light of the light-emitting element 100A.

The photonic crystal-surface emitting laser 100 includes the plurality of light-emitting elements 100A arrayed in an in-plane direction. In addition, the laser driver 200 includes the plurality of switching elements that correspond to the plurality of light-emitting elements 100A. Each of the plurality of switching elements is coupled to either one of the first and second electrodes 109 and 112 (for example, the first electrode 109) used to energize the corresponding light-emitting element 100A. This configuration makes it possible to separately drive each of the plurality of light-emitting elements 100A. That is, it is possible to selectively drive at least one light-emitting element 100A from among the plurality of light-emitting elements 100A. In this case, it may be possible to employ a configuration in which at least two light-emitting elements 100A having different properties (for example, an output angle, an output direction, a polarization direction, output, or the like) are included in the plurality of light-emitting elements 100A.

The photonic crystal-surface emitting laser 100 is desired to be a photonic crystal-surface emitting laser in which the positions and/or the sizes of individual lattice points of the photonic crystal layer are modulated and are disposed to output a beam in a predetermined direction. In this case, delay (oscillation delay) of output timing of a group of beams outputted from the same light-emitting element 100A is substantially the same (< less than 2 ps). Thus, calibration such as delay compensation is not necessary for the laser driver 200, and hence, in particular, it is possible to favorably use the light source apparatus 10 as a light source apparatus embedded in a range finder. Note that, since the oscillation delay of a group of beams is substantially the same, it is possible to reduce a variation in distance measurement.

The photonic crystal-surface emitting laser 100 includes the reflecting mirror 107 provided on the laser driver 200 side with respect to the active layer 104 and the photonic crystal layer 105. This makes it possible to improve the light utilization efficiency. A supplemental description will be made. In a case of a photonic crystal-surface emitting laser that forms a two-dimensional standing-wave state in an in-plane direction, it is possible to achieve a desired function without a reflecting mirror. However, as surface light emission is performed, light is outputted from both sides in the layering direction. Thus, by providing the reflecting mirror at the laser driver 200 side, it is possible to take out light outputted toward the laser driver 200 side as back-surface output light, which is not taken out in the existing apparatus. This makes it possible to achieve an approximately twofold improvement in the light utilization efficiency.

Incidentally, for example, a light source apparatus using a VCSEL as a light source typically includes an optical element that controls the spreading angle or the output direction of the output light of the VCSEL. This is because, since light outputted from a typical VCSEL spreads out, it is necessary to provide a collimating lens for collecting light to a target object or a diffraction grating for separating light into various directions or the like.

In contrast, the light source apparatus 10 according to the First Example of one embodiment of the present technology uses the PCSEL as the light source. This makes it possible to achieve a narrow beam divergence due to the photonic crystal. Thus, the collimating lens is not essential. In addition, the light source apparatus 10 is able to output a beam in a predetermined direction due to the feature of the PCSEL. Thus, the diffraction grating is not essential. Since an optical element such as the collimating lens or the diffraction grating is not essential, it is possible to reduce the size of the light source unit, and also possible to reduce the cost by the amount of the optical element, which are advantageous.

In addition, in particular, in a case of a semiconductor layer used in a distance measurement application, it is desired to drive the light source at faster speed in order to improve the distance measurement performance. It is known that the speed of drive of the light source is largely influenced by a portion where the semiconductor laser is mounted. When wire bonding is performed by using a wiring including a material such as gold, the wiring serves as a factor of inductance, which may serve as a large factor of preventing a driving pulse from entering at a high speed. In a case of the light source apparatus 10, the photonic crystal-surface emitting laser 100 is mounted (directly) at the laser driver 200 through the bumps, and hence is excellent also in terms of high-speed driving.

### <2. Light source apparatus according to the Second Example of one embodiment of the present technology>

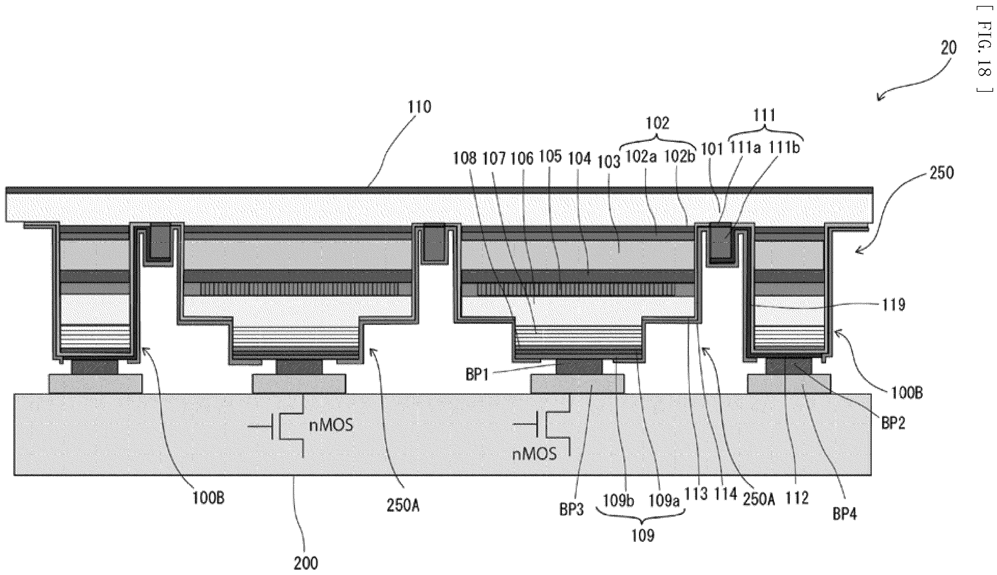

FIG. 18 is a cross-sectional view of a light source apparatus 20 according to the Second Example of one embodiment of the present technology. The light source apparatus 20 according to the Second Example has a configuration similar to that of the light source apparatus 10 according to the First Example except that a light-emitting element 250A of a photonic crystal-surface emitting laser 250 includes a small diameter portion at the laser driver 200 side, as illustrated in FIG. 18.

A portion (for example, portions including a portion of the second clad layer 106, the reflecting mirror 107, and the contact layer 108) of the light-emitting element 250A at the laser driver 200 side constitutes a small diameter portion having a smaller diameter (for example, substantially the same size as the first electrode 109) than the other portions (for example, portions including the tunnel junction layer 102, the first clad layer 103, the active layer 104, the photonic crystal layer 105, and the other portion of the second clad layer 106). This configuration makes it possible to cause a current flowing into the light-emitting element 100A to flow so as to concentrate on the central portion of the light-emitting element 100A.

With the light source apparatus 20, it is possible to obtain the effects similar to those of the light source apparatus 10 according to the First Example, and also possible to narrow the current path (specifically, limit the current path to the central portion) in the light-emitting element 250A. This makes it possible to reduce a leakage current that does not contribute to emission of light, and also possible to improve the light emission efficiency.

Note that the light-emitting element may include the small diameter portion on the opposite side from the laser driver 200 side.

### <3. Light source apparatus according to the Third Example of one embodiment of the present technology>

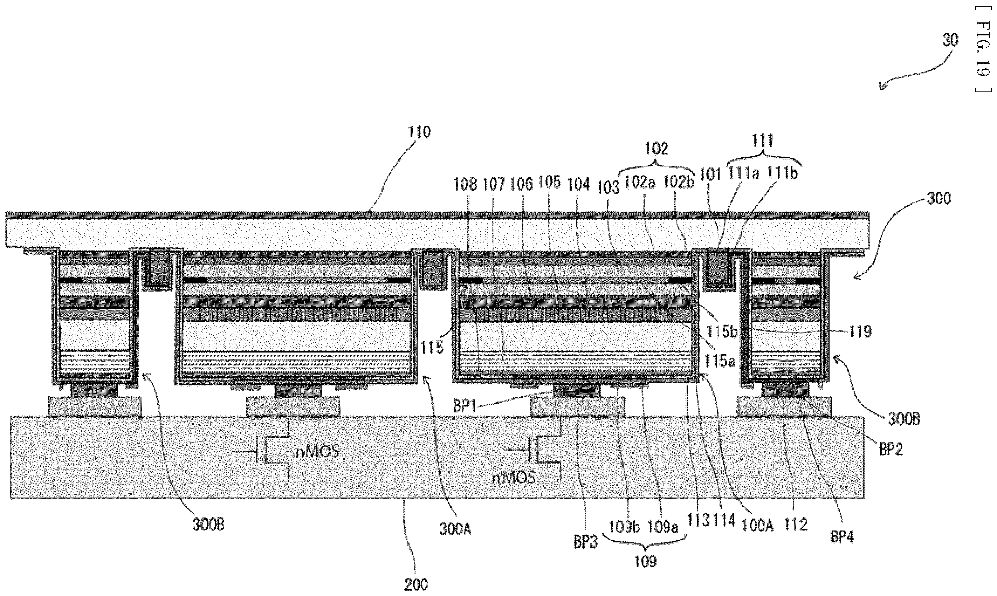

FIG. 19 is a cross-sectional view of a light source apparatus 30 according to the Third Example of one embodiment of the present technology. The light source apparatus 30 according to the Third Example has a configuration similar to that of the light source apparatus 10 according to the First Example except that a photonic crystal-surface emitting laser 300 includes an oxidation confining layer 115 serving as a current confining layer.

In the photonic crystal-surface emitting laser 300, the oxidation confining layer 115 is disposed within the first clad layer 103, as one example. The oxidation confining layer 115 includes p-Alx12Ga1-x12As (0 < x12 ≦ 1), for example. The oxidation confining layer 115 includes a non-oxidation region 115a and an oxidation region 115b that surrounds the non-oxidation region 115a. The non-oxidation region 115a includes a region including a semiconductor (for example, p-AlGaAs) and having a relatively high refractive index, and functions as a current and light passing region. The oxidation region 115b includes a region including an insulating body (for example, Al2O3) and having a relatively low refractive index, and functions as a current and light confining region. The oxidation confining layer 115 is formed by forming a mesa including a selected oxidation layer (for example, p-AlGaAs) serving as a material, and then, selectively performing oxidation processing to high concentration Al of this selected oxidation layer under steam conditions and at high temperatures from the side surface.

With the light source apparatus 30, it is possible to obtain the effects similar to those of the light source apparatus 10 according to the First Example, and also possible to confine the current by the oxidation confining layer 115 disposed within the first clad layer 103 including a p-type semiconductor layer in which a hole having a lower movement degree serves as a carrier. The photonic crystal-surface emitting laser 300 has a configuration in which a current is caused to flow from the periphery of the light-emitting element 300A. Thus, by confining the current at the p-side, it is possible to confine the current entering the active layer 104. This makes it possible to cause the current to enter a desired region (for example, the central region) of the active layer 104. In addition, it is possible to confine light (light confinement).

### <4. Light source apparatus according to the Fourth Example of one embodiment of the present technology >

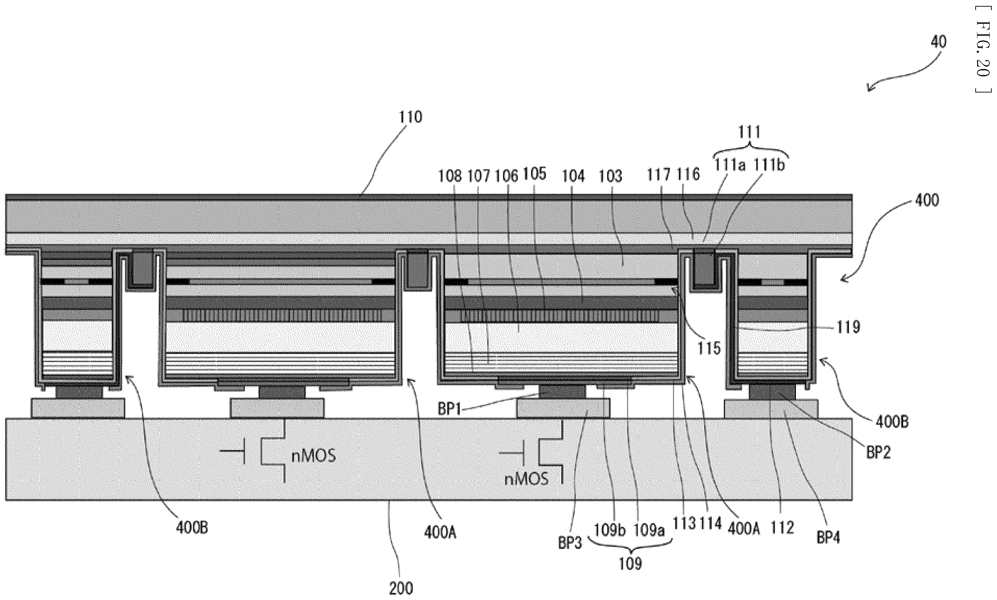

FIG. 20 is a cross-sectional view of a light source apparatus 40 according to the Fourth Example of one embodiment of the present technology. The light source apparatus 40 according to the Fourth Example has a configuration similar to that of the light source apparatus 30 according to the Third Example except that a photonic crystal-surface emitting laser 400 includes a current spreading layer 116 and an etching stopping layer 117 in place of the tunnel junction layer 102.

In the photonic crystal-surface emitting laser 400, the substrate 101 includes a semi-insulating substrate or an insulating substrate (for example, SI substrate: Semi-Insulating Substrate), and the photonic crystal-surface emitting laser 400 includes the current spreading layer 116 serving as a low-resistance layer provided closer to the substrate 101 than the active layer 104 and the photonic crystal layer 105 and having a lower resistance than the substrate 101. The current spreading layer 116 includes a high-dope p-GaAs as one example, and is provided so as to be in contact with a surface of the substrate 101 that is at the active layer 104 side. The etching stopping layer 117 includes InGaP, as one example, and is disposed between the current spreading layer 116 and the first clad layer 103. Here, the current spreading layer 116 is doped with p-type impurities such as Zn, Mg, Be, or C, for example.

In the light source apparatus 40, a current applied from the laser driver 200 passes through the second electrode 112, the wiring 119, the intermediate electrode 111, and the etching stopping layer 117, and flows into the current spreading layer 116. The current that has flown into the current spreading layer 116 spreads in an in-plane direction of the current spreading layer 116, and flows into the light-emitting element 400A through the etching stopping layer 117.

With the light source apparatus 40, since the SI substrate is used for the substrate 101, it is possible to suppress absorption of the light outputted from the photonic crystal layer 105 at the time of passing through the substrate 101, and also possible to achieve a light source apparatus having high light utilization efficiency.

Note that, in a case where the etching controllability at the time of forming the mesas is favorable (in a case where the mesas can be formed such that the current spreading layer 116 is not etched), the light source apparatus 40 may not include the etching stopping layer 117.

### <5. Light source apparatus according to the Fifth Example of one embodiment of the present technology>

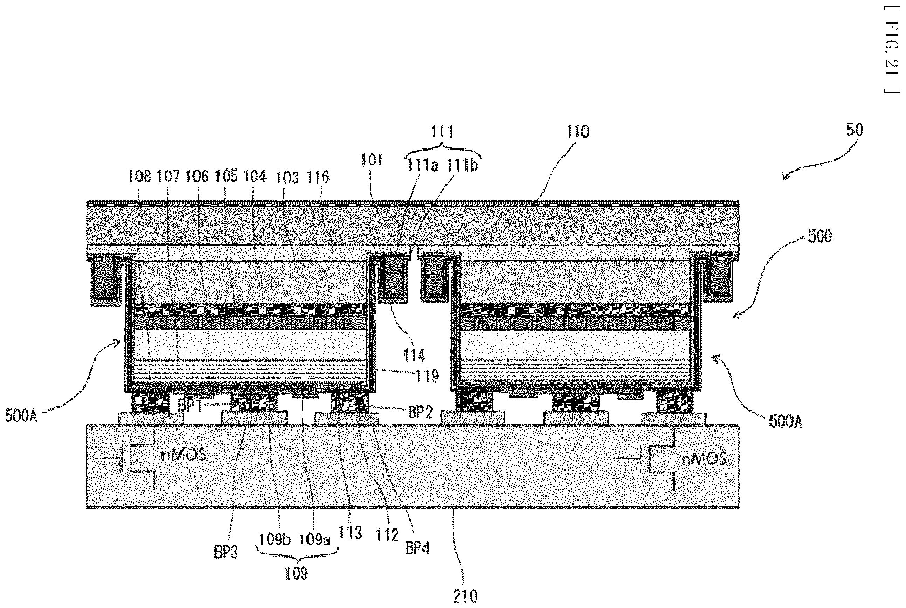

FIG. 21 is a cross-sectional view of a light source apparatus 50 according to the Fifth Example of one embodiment of the present technology. FIG. 21 is a cross-sectional view of the light source apparatus 50. The light source apparatus 50 according to the Fifth Example has a configuration generally similar to that of the light source apparatus 10 according to the First Example except that: the first and second electrodes 109 and 112 are provided on a surface of a light-emitting element 500A, the surface being disposed at the laser driver 200 side; the current spreading layer 116 is provided in place of the tunnel junction layer 102; and conductivity types are reversed between layers on both sides of the active layer 104 in the layering direction.

In the light source apparatus 50, a photonic crystal-surface emitting laser 500 is configured such that the current spreading layer 116 and the first clad layer 103 include an n-type semiconductor, and the second clad layer 106, the reflecting mirror 107, and the contact layer 108 include a p-type semiconductor. Here, the current spreading layer 116 is doped with n-type impurities such as Si, Se, Te, or Ge, for example.

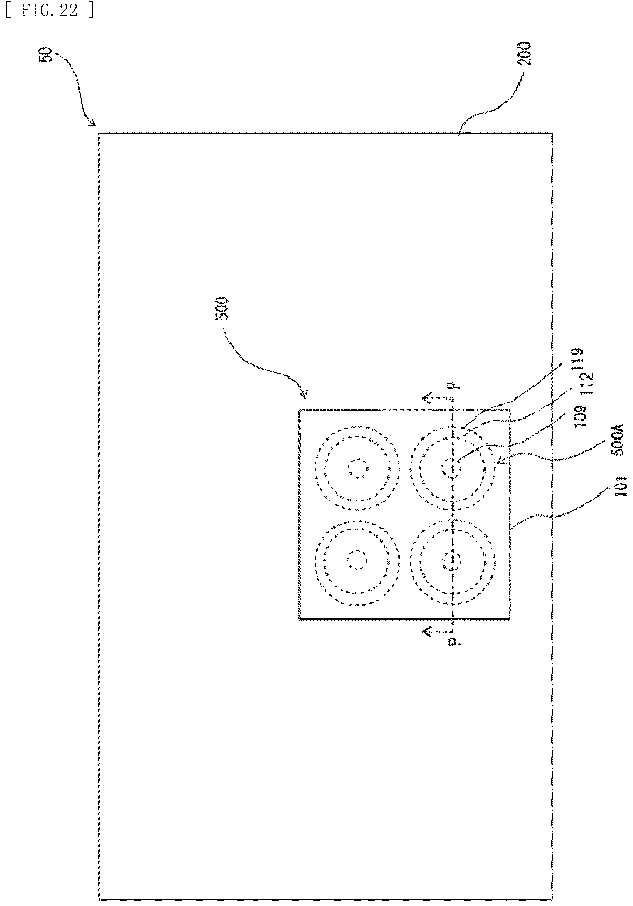

The photonic crystal-surface emitting laser 500 includes a substrate 101 on which a light-emitting element 500A is provided in a protruding manner, and also includes the wiring 119 coupled to the second electrode 112 and extending from the second electrode 112 side along the light-emitting element 500A to the substrate 101 side, as illustrated in FIGs. 21 and 22. The second electrode 112 is coupled to the nMOS through the second and fourth bumps BP2 and BP4.

The photonic crystal-surface emitting laser 500 includes the intermediate electrode 111 directly or indirectly (for example, directly) provided on the substrate 101 and coupled to the wiring 119.

In the photonic crystal-surface emitting laser 500, the substrate 101 includes a semi-insulating substrate or an insulating substrate (for example, SI substrate), and the photonic crystal-surface emitting laser 500 includes the current spreading layer 116 serving as a low-resistance layer provided closer to the substrate 101 than the active layer 104 and the photonic crystal layer 105 and having a lower resistance than the substrate 101. The current spreading layer 116 includes a high-dope n-GaAs, for example, and is disposed between the substrate 101 and the first clad layer 103. The intermediate electrode 111 is provided in a circular manner (for example, in a ring-shaped manner) so as to surround the light-emitting element 500A and be in contact with the current spreading layer 116, for example. The current spreading layer 116 is provided so as to be separated for each light-emitting element 500A. That is, the photonic crystal-surface emitting laser 500 includes a plurality of sets of the light-emitting element 500A, the first and second electrodes 109 and 112, and the intermediate electrode 111, the sets being provided on the SI substrate serving as the substrate 101 in a semi-insulating state.

In the photonic crystal-surface emitting laser 500, the first electrode 109 provided at the central portion of the top portion of the light-emitting element 500A serves as an anode electrode, and the second electrode 112 provided at the peripheral portion of the top portion of the light-emitting element 500A in a circular manner so as to surround the first electrode 109 serves as a cathode electrode, as one example. The first electrode 109 is coupled to the anode side of the power supply of the laser driver 210 through the first and third bumps BP1 and BP3. The second electrode 112 is coupled to the drain of the nMOS of the laser driver 210 through the second and fourth bumps BP2 and BP4. The first electrodes 109 of the plurality of light-emitting elements 500A are coupled directly to the p-type semiconductor substrate of the laser driver 210, and are in a common electrode state (state of anode common) within this semiconductor substrate.

With the light source apparatus 50, it is possible to reduce the absorption of light by the substrate 101 and also possible to reduce the size of the photonic crystal-surface emitting laser 500.

Note that the light source apparatus 50 may employ a configuration using a semiconductor substrate (for example, an n-GaAs substrate) serving as the substrate 101 and the tunnel junction layer 102. In this case, for example, the tunnel junction layer 102 may be provided on the laser driver 200 side with respect to the active layer 104 and the photonic crystal layer 105, or it may be possible to employ a configuration in which the conductive type of the semiconductor layer of the light-emitting element 500A is similar to that of the light-emitting element 100A of the light source apparatus 10 according to the First Example, the second electrode 112 serves as the anode electrode, and the first electrode 109 serves as the cathode electrode to be coupled to the nMOS.

### <6. Light source apparatus according to the Sixth Example of one embodiment of the present technology>

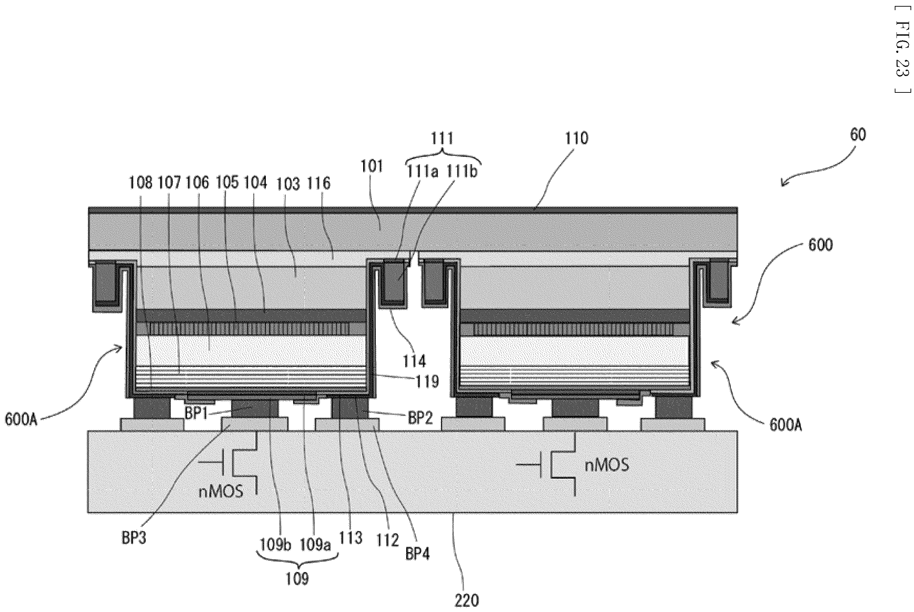

FIG. 23 is a cross-sectional view of a light source apparatus 60 according to the Sixth Example of one embodiment of the present technology. The light source apparatus 60 according to the Sixth Example has a configuration similar to that of the light source apparatus 50 according to the Fifth Example except that: conductivity types of a photonic crystal-surface emitting laser 600 are reversed between layers on both sides of the active layer 104; the first electrode 109 serves as the cathode electrode; and the second electrode 112 serves as the anode electrode.

In the photonic crystal-surface emitting laser 600, the nMOS is coupled to the cathode electrode as the first electrode 109.

With the light source apparatus 60, it is possible to obtain the effects similar to those of the light source apparatus 50 according to the Fifth Example.

### <7. Light source apparatus according to the Seventh Example of one embodiment of the present technology>

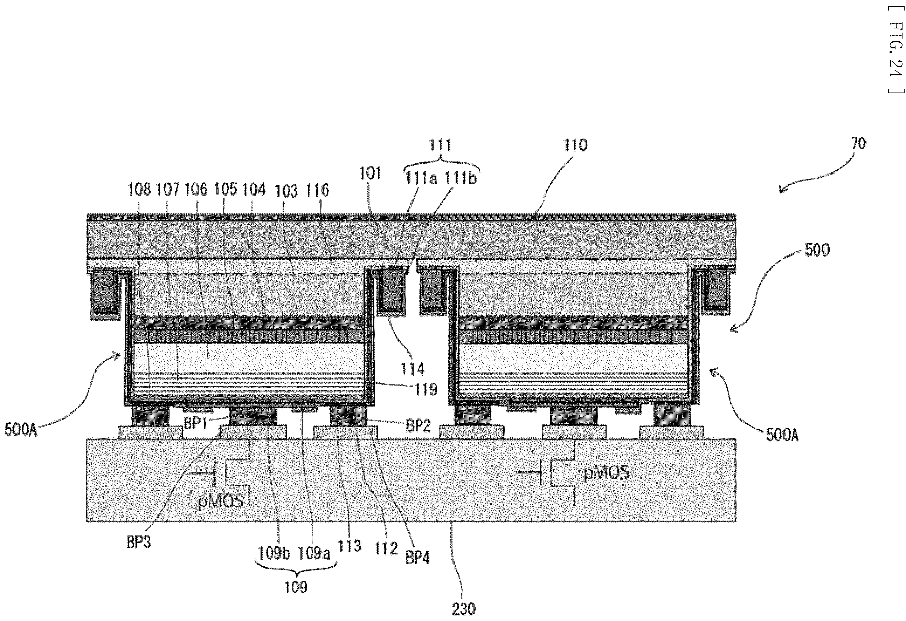

FIG. 24 is a cross-sectional view of a light source apparatus 70 according to the Seventh Example of one embodiment of the present technology. The light source apparatus 70 according to the Seventh Example has a configuration generally similar to the light source apparatus 50 according to the Fifth Example except that the conductivity type of the switching element of the laser driver 230 differs.

In the light source apparatus 70, the laser driver 230 includes a pMOS (p-type MOSFET) in place of the nMOS, and this pMOS is coupled to the anode electrode as the first electrode 109.

With the light source apparatus 70, it is possible to obtain the effects similar to those of the light source apparatus 50 according to the Fifth Example.

### <8. Light source apparatus according to the Eighth Example of one embodiment of the present technology>

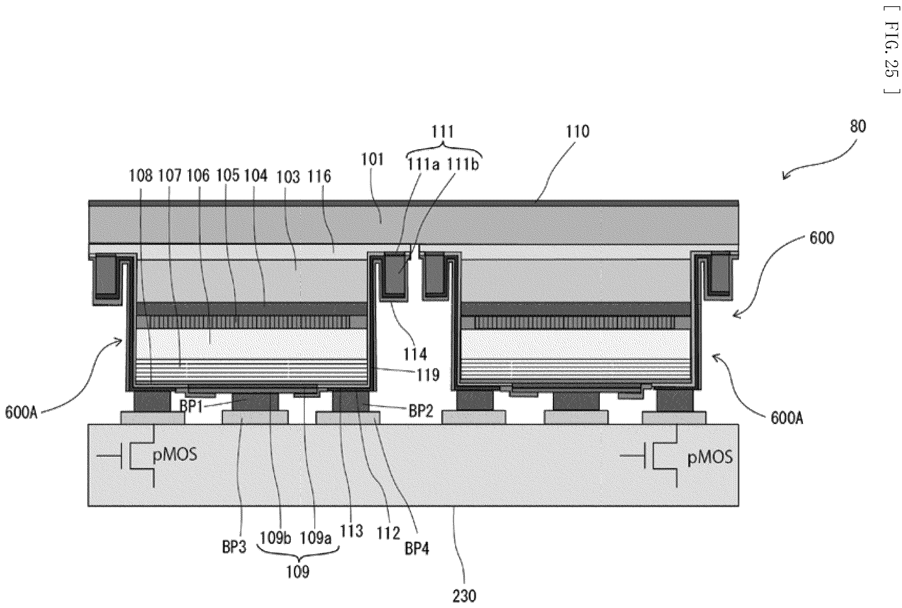

FIG. 25 is a cross-sectional view of a light source apparatus 80 according to the Eighth Example of one embodiment of the present technology. The light source apparatus 80 according to the Eighth Example has a configuration similar to that of the light source apparatus 60 according to the Sixth Example except that the conductivity type of the switching element of the laser driver 230 differs.

In the light source apparatus 80, the laser driver 230 includes a pMOS (p-type MOSFET) in place of the nMOS, and this pMOS is coupled to the anode electrode as the second electrode 112.

With the light source apparatus 80, it is possible to obtain the effects similar to those of the light source apparatus 60 according to the Sixth Example.

### <9. Light source apparatus according to the Ninth Example of one embodiment of the present technology>

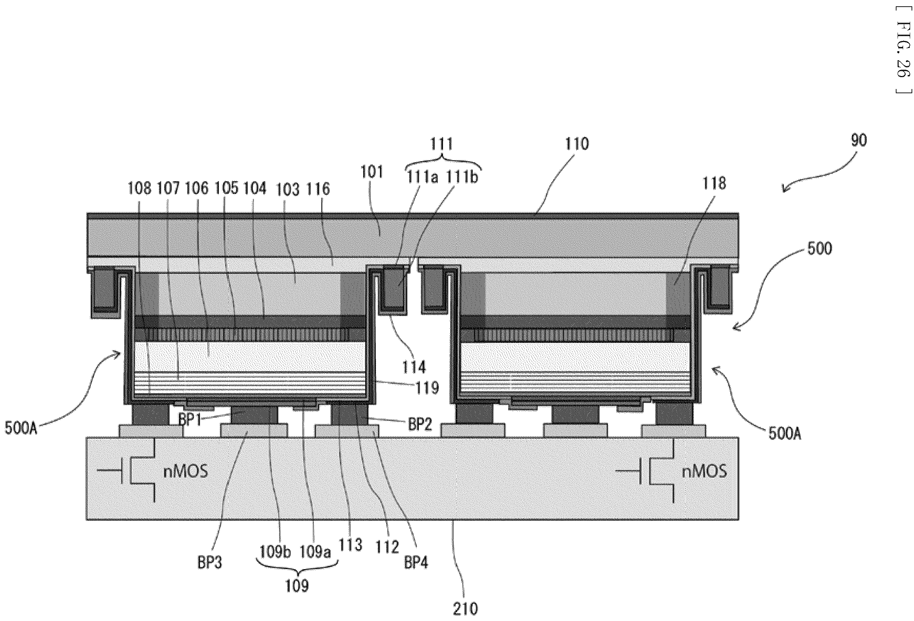

FIG. 26 is a cross-sectional view of a light source apparatus 90 according to the Ninth Example of one embodiment of the present technology. The light source apparatus 90 according to the Ninth Example has a configuration similar to that of the light source apparatus 50 according to the Fifth Example except that the light-emitting element 500A includes an ion implantation region 118 serving as a current confining region.

The ion implantation region 118 is provided in a circular manner (for example, in an annular manner) at a peripheral portion of the first clad layer 103, the active layer 104, and the photonic crystal layer 105, as one example.

With the light source apparatus 90, the ion implantation region 118 enables a current to be confined. This makes it possible to improve the current entrance efficiency into the active layer 104, and also possible to improve the light emission efficiency of the active layer 104.

Note that an ion implantation region IIA is only necessary to be provided at at least a portion of the light-emitting element 500A in the layering direction. For example, in place of or in addition to the peripheral portion of the first clad layer 103, the active layer 104, and the photonic crystal layer 105, the ion implantation region IIA may be provided at a peripheral portion of the second clad layer 106, the reflecting mirror 107, and the contact layer 108.

### <10. Light source apparatus according to the Tenth Example of one embodiment of the present technology>

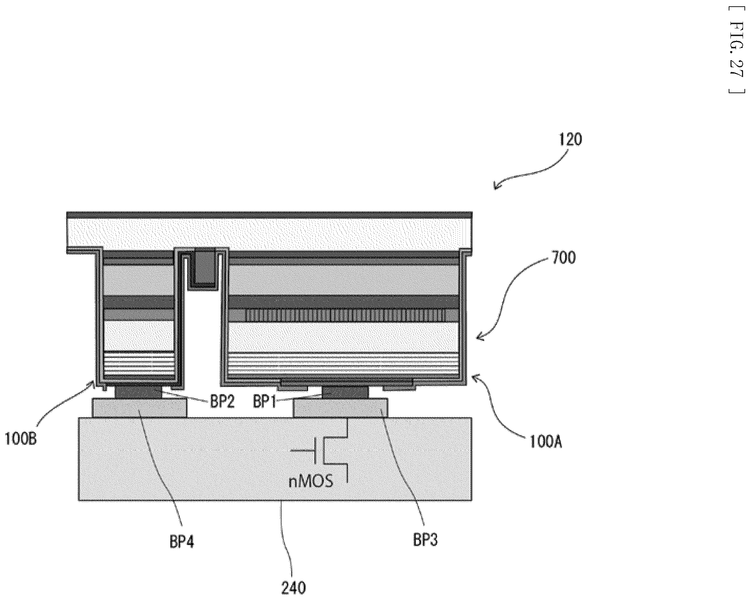

FIG. 27 is a cross-sectional view of a light source apparatus 120 according to the Tenth Example of one embodiment of the present technology. The light source apparatus 120 according to the Tenth Example has a configuration similar to that of the light source apparatus 10 according to the First Example except that a photonic crystal-surface emitting laser 700 includes one light-emitting element 100A and one pedestal 100B.

In the light source apparatus 120, a laser driver 240 includes one nMOS, and the nMOS is coupled to the light-emitting element 100A through the first and third bumps BP1 and BP3, as one example.

With the light source apparatus 120, it is possible to provide a light source apparatus including a single light-emitting element 100A and having a configuration including a portion of the light source apparatus 10 according to the First Example.

### <11. Light source apparatus according to the Eleventh Example of one embodiment of the present technology>

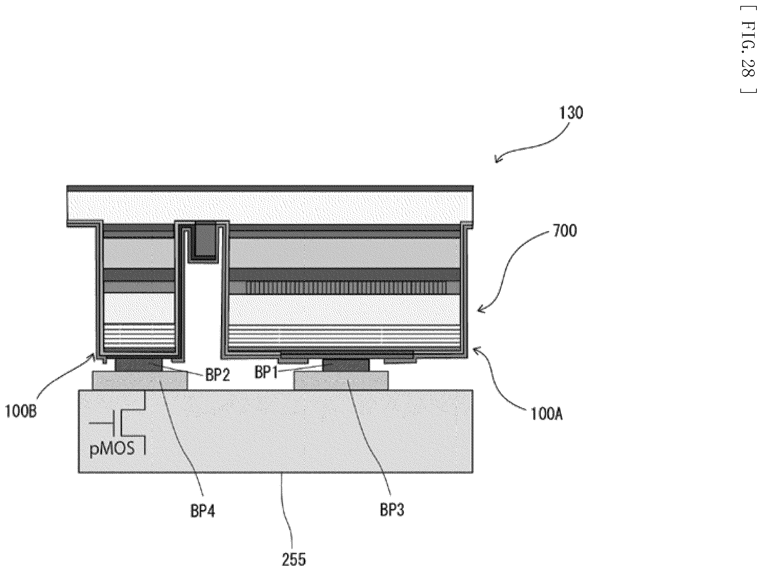

FIG. 28 is a cross-sectional view of a light source apparatus 130 according to the Eleventh Example of one embodiment of the present technology. The light source apparatus 130 according to the Eleventh Example has a configuration similar to that of the light source apparatus 120 according to the Tenth Example except that a laser driver 255 includes one pMOS, and this pMOS is coupled to the pedestal 100B through the second and fourth bumps BP2 and BP4.

With the light source apparatus 130, it is possible to obtain the effects similar to those of the light source apparatus 120 according to the Tenth Example.

### <12. Light source apparatus according to the Twelfth Example of one embodiment of the present technology>

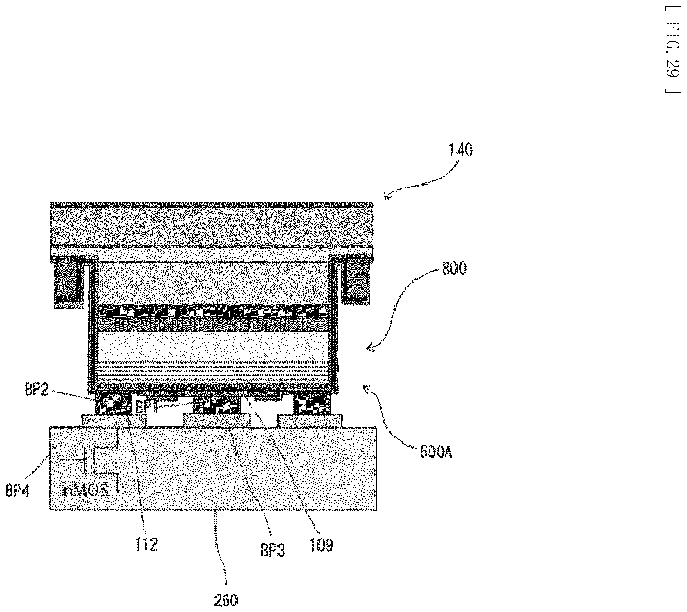

FIG. 29 is a cross-sectional view of a light source apparatus 140 according to the Twelfth Example of one embodiment of the present technology. The light source apparatus 140 according to the Twelfth Example has a configuration similar to that of the light source apparatus 50 according to the Fifth Example except that a photonic crystal-surface emitting laser 800 includes a single light-emitting element 500A.

In the light source apparatus 140, a laser driver 260 includes one nMOS, and this nMOS is coupled to the second electrode 112 (cathode electrode) of the light-emitting element 500A through the second and fourth bumps BP2 and BP4, as one example.

With the light source apparatus 140, it is possible to provide a light source apparatus including the single light-emitting element 500A and having a configuration including a portion of the light source apparatus 50 according to the Fifth Example.

### <13. Light source apparatus according to the Thirteenth Example of one embodiment of the present technology>

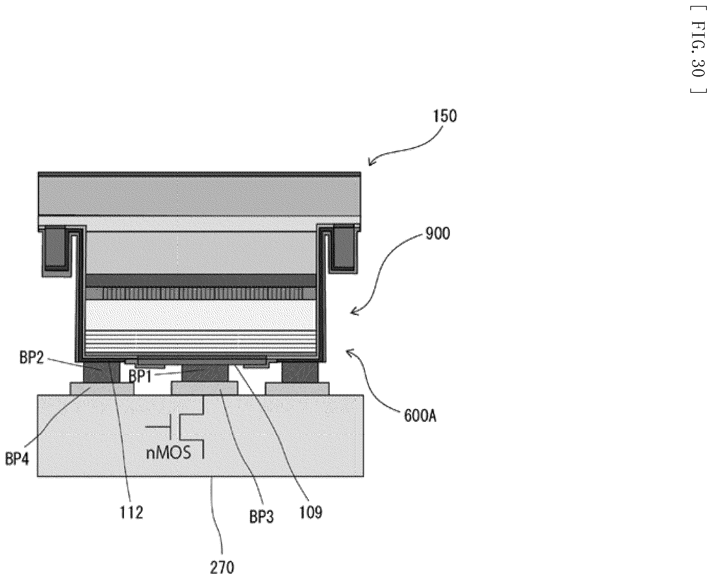

FIG. 30 is a cross-sectional view of a light source apparatus 150 according to the Thirteenth Example of one embodiment of the present technology. The light source apparatus 150 according to the Thirteenth Example has a configuration similar to that of the light source apparatus 140 according to the Twelfth Example except that conductivity types are reversed between layers on both sides of the active layer of a photonic crystal-surface emitting laser 900 in the layering direction, and a laser driver 270 includes one nMOS coupled to the first electrode 109 (cathode electrode) through the first and third bumps BP1 and BP3.

With the light source apparatus 150, it is possible to obtain the effects similar to the light source apparatus 140 according to the Twelfth Example.

### <14. Light source apparatus according to the Fourteenth Example of one embodiment of the present technology>

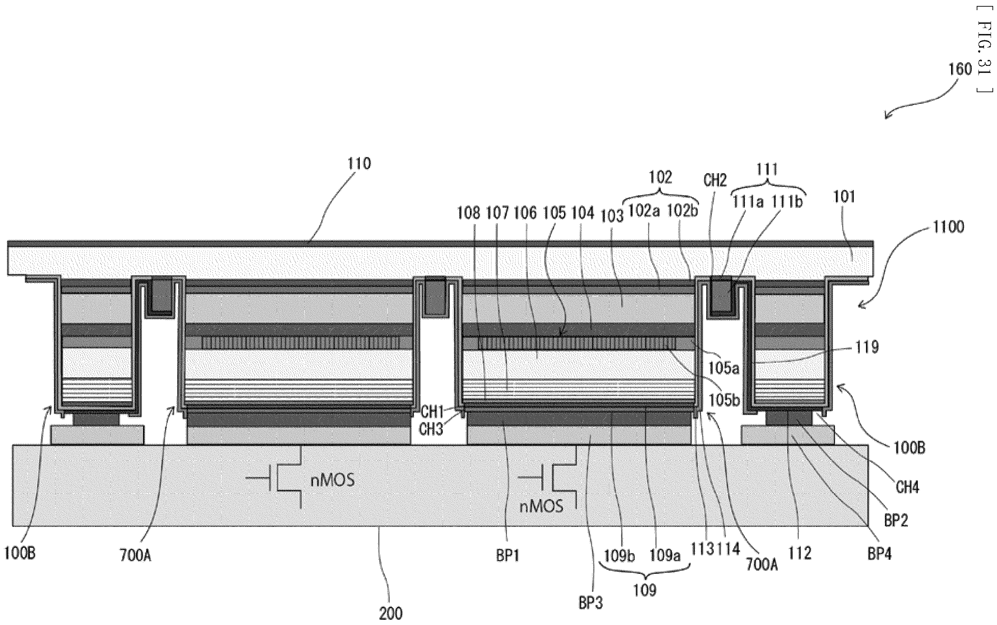

FIG. 31 is a cross-sectional view of a light source apparatus 160 according to the Fourteenth Example of one embodiment of the present technology. The light source apparatus 160 according to the Fourteenth Example has a configuration generally similar to that of the light source apparatus 10 according to the First Example except that the first and third bumps BP1 and BP3 that couple a light-emitting element 700A of a photonic crystal-surface emitting laser 1100 and the laser driver 200 are provided so as to have a size equivalent to the entire top portion of the light-emitting element 700A.

In the photonic crystal-surface emitting laser 1100, the first and third contact holes CH1 and CH3 are provided over substantially the entire region of the top portion of the light-emitting element 700A, and the first electrode 109 is provided over substantially the entire region of the inside of the first and third contact holes CH1 and CH3.

Incidentally, in a case of the photonic crystal-surface emitting laser, as the distribution of temperatures of the light-emitting element becomes excessively large, the resonance breaks, which leads to a problem of deterioration in the light-emission control. The light source apparatus 160 includes the first and third bumps BP1 and BP3 provided so as to correspond to substantially the entire range of the light-emitting element 700A, and hence, is excellent in thermal dissipation. By increasing the sizes of the first and third bumps BP1 and BP3, it is possible to obtain an effect of suppressing an increase in temperatures of the light-emitting element 700A and also obtain an effect of making uniform the distribution of in-plane temperatures of the light-emitting element 700A.

### <15. Modification example of present technology>

The present technology is not limited to each of the Examples of one embodiment described above, and is able to take various modification examples. For example, in each of the Examples described above, the bumps are provided for the photonic crystal-surface emitting laser and the laser driver. However, the configuration is not limited to this. It is only necessary that the bumps are provided at at least either one of the photonic crystal-surface emitting laser and the laser driver.

For example, in each of the Examples described above, the bumps provided at the photonic crystal-surface emitting laser and the laser driver include various types of materials. However, these bumps may include the same type of material (including the same material).

For example, in each of the Examples described above, the semiconductor multi-layer-film reflecting mirror is used for the reflecting mirror. However, the configuration is not limited to this. For example, it may be possible to use a dielectric multilayer reflecting mirror or a hybrid mirror including at least two of semiconductor multi-layer-film reflecting mirror, dielectric multilayer reflecting mirror, and a metal reflecting mirror.

For example, in each of the Examples described above, the photonic crystal-surface emitting laser includes a material lattice matched to GaAs. However, the material is not limited to this. For example, it may be possible to use a material lattice matched to GaN or a material lattice matched to InP.

It is possible to modify the layer configuration of the first and second electrodes 109 and 112 on an as-necessary basis.

The contact layer 108 may not be provided.

The reflecting mirror 107 may not be provided.

The shapes of the light-emitting element and the pedestal in plan view are not limited to a circular shape, and may be a polygonal shape, an oval shape, or the like, for example.

For example, in each of the Examples described above, MOSFET is used as a switching element of the laser driver. However, it may be possible to use other field effect transistors such as a bonding FET or use a bipolar transistor, for example.

It may be possible to combine portions of the configuration of the light source apparatus according to each of the Examples as long as they do not contradict each other.

In each of the Examples, it may be possible to appropriately modify the material, the conductivity type, the thickness, the width, the numerical values, the shape, the size, and the like of the individual layers that constitute the photonic crystal-surface emitting laser and the laser driver of the light source apparatus within the extent in which the modifications function as a light source apparatus.

### <16. Application example to electronic apparatus>

It is possible to apply the technique (the present technology) according to the present disclosure to various products (electronic devices). For example, the technique of the present disclosure may be achieved as an apparatus to be mounted on a mobile body of any one type of an automobile, an electric car, a hybrid electric car, a motorcycle, a bicycle, a personal mobility, an airplane, a drone, a ship, a robot, or the like, or may be achieved as an apparatus to be mounted on a low-electric-consumption electrical power device (for example, a smartphone, a smartwatch, a tablet, a mouse, and the like).

It is possible to use the light source apparatus according to the present technology as a light source in a device (for example, a laser printer, a laser copy machine, a projector, a head-mounted display, a head-up display, or the like) that forms or displays an image using laser light, for example.

### <17. Example in which light source apparatus is applied to distance measuring apparatus>

Below, description will be made of an application example of the light source apparatus 10 according to the First Example described above.

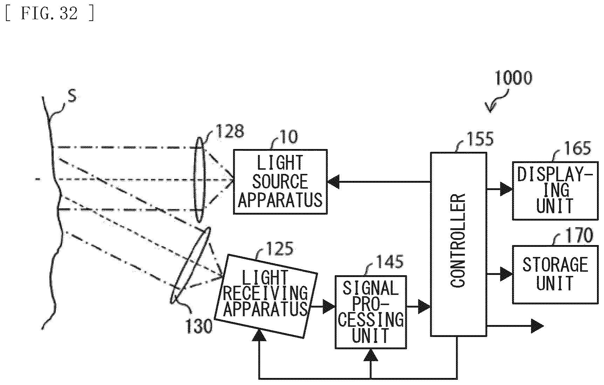

FIG. 32 is a diagram illustrating one example of the schematic configuration of a distance measuring apparatus 1000 (range finder) including the light source apparatus 10 and serving as one example of an electronic device according to the present technology. The distance measuring apparatus 1000 uses a TOF (Time Of Flight) method to measure a distance to a target object S. The distance measuring apparatus 1000 includes the light source apparatus 10. The distance measuring apparatus 1000 includes the light source apparatus 10, a light receiving apparatus 125, lenses 128 and 130, a signal processing unit 145, a controller 155, a displaying unit 165, and a storage unit 170, for example.

The light receiving apparatus 125 receives light outputted from the light source apparatus 10 and reflected by the target object S (object). That is, the light receiving apparatus 125 detects light reflected by the target object S. A lens element that constitutes the lens 128 is used to collimate the light outputted from the photonic crystal-surface emitting laser 100, and includes a collimating lens, for example. The light outputted from the photonic crystal-surface emitting laser 100 has already been collimated from the beginning due to its property. This makes it possible to minimize the number of lenses 128 necessary for obtaining the desired beam quality, and also possible to reduce the number of lenses as compared with the existing surface emitting laser (for example, VCSEL). Furthermore, another feature of the photonic crystal-surface emitting laser 100 is that it has a function of being able to output a plurality of beams of light in desired directions, and generally has a function of a diffraction grating or the like. In a typical usage mode, this function is included in the external lens 128. The lens 130 collects the light reflected by the target object S to guide it to the light receiving apparatus 125, and includes a condensing lens, for example.

The signal processing unit 145 includes a circuit used to generate a signal corresponding to a difference between a signal inputted from the light receiving apparatus 125 and a reference signal inputted from the controller 155. The controller 155 includes a Time to Digital Converter (TDC), for example. The reference signal may be a signal inputted from the controller 155 or may be an output signal from a detector that directly detects the output from the photonic crystal-surface emitting laser 100. The controller 155 includes a processor that controls the photonic crystal-surface emitting laser 100, the light receiving apparatus 125, the signal processing unit 145, the displaying unit 165, and the storage unit 170, for example. The controller 155 includes a circuit that measures the distance to the target object S on the basis of the signal generated by the signal processing unit 145. The controller 155 generates an image signal used to display information regarding the distance to the target object S, and outputs it to the displaying unit 165. The displaying unit 165 displays the information regarding the distance to the target object S on the basis of the image signal inputted from the controller 155. The controller 155 stores, in the storage unit 170, the information regarding the distance to the target object S.

In the present application example, in place of the light source apparatus 10, it may be possible to apply, to the distance measuring apparatus 1000, any one of the light source apparatuses 20, 30, 40, 50, 60, 70, 80, 90, 120, 130, 140, 150, and 160 described above.

### <18. Example in which distance measuring apparatus is applied to mobile body>

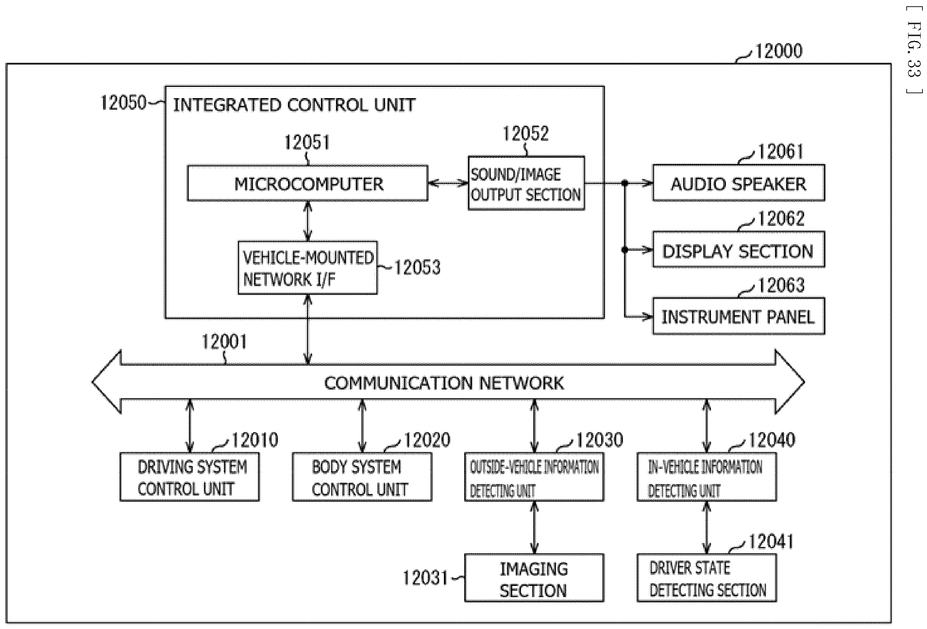

FIG. 33 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 33, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with a distance measuring apparatus 12031. The distance measuring apparatus 12031 includes the distance measuring apparatus 1000 described above. The outside-vehicle information detecting unit 12030 may cause the distance measuring apparatus 1000 to measure a distance to an object (object S) outside the vehicle, and acquire distance data obtained by the measurement. On the basis of the acquired distance data, the outside-vehicle information detecting unit 12030 may perform processing of detecting an object such as a human, a vehicle, an obstacle, a sign, a character on a road surface, or the like, or processing of detecting a distance thereto.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automatic driving, which makes the vehicle to travel autonomously without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 33, an audio speaker 12061, a display section 12062, and an instrument panel 12063 are illustrated as the output device. The display section 12062 may, for example, include at least one of an on-board display and a head-up display.

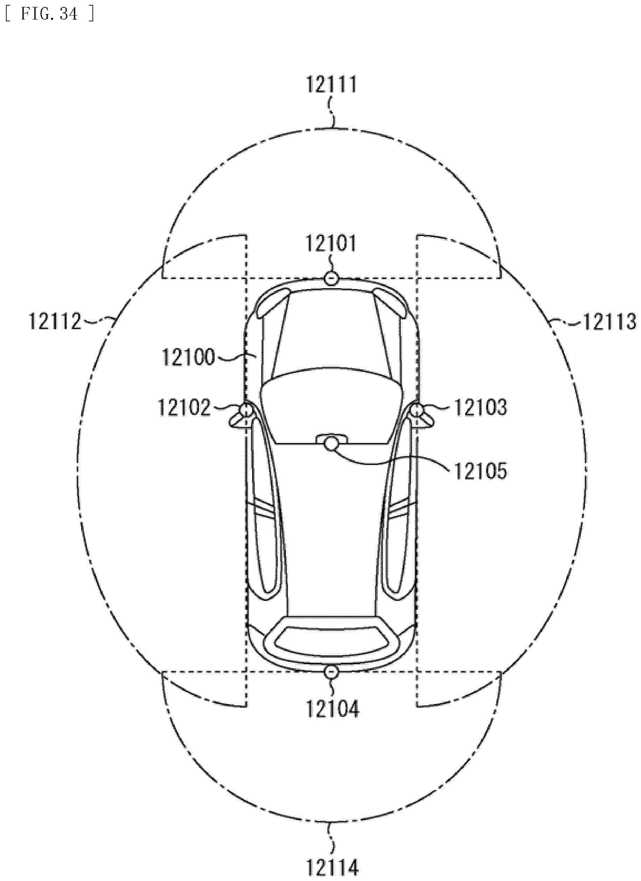

FIG. 34 is a diagram depicting an example of the installation position of the distance measuring apparatus 12031.

In FIG. 34, the vehicle 12100 includes distance measuring apparatuses 12101, 12102, 12103, 12104, and 12105 as the distance imaging apparatus 12031.

The distance measuring apparatuses 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The distance measuring apparatus 12101 provided to the front nose and the distance measuring apparatus 12105 provided to the upper portion of the windshield within the interior of the vehicle obtain mainly data on the front of the vehicle 12100. The distance measuring apparatuses 12102 and 12103 provided to the sideview mirrors obtain mainly data on the sides of the vehicle 12100. The distance measuring apparatus 12104 provided to the rear bumper or the back door obtains mainly data on the rear of the vehicle 12100. The data on the front acquired by the distance measuring apparatuses 12101 and 12105 is used mainly to detect a preceding vehicle, a pedestrian, an obstacle, a signal, a traffic sign, a lane, or the like.

Incidentally, FIG. 34 depicts an example of detection ranges of the distance measuring apparatuses 12101 to 12104. A detection range 12111 represents the detection range of the distance measuring apparatus 12101 provided to the front nose. Detection ranges 12112 and 12113 respectively represent the detection ranges of the distance measuring apparatuses 12102 and 12103 provided to the sideview mirrors. A detection range 12114 represents the imaging range of the distance measuring apparatus 12104 provided to the rear bumper or the back door.

For example, the microcomputer 12051 can determine a distance to each three-dimensional object within the detection ranges 12111 to 12114 and a temporal change in the distance (relative speed with respect to the vehicle 12100) on the basis of the distance data obtained from the distance measuring apparatuses 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automatic driving that makes the vehicle travel autonomously without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance data obtained from the distance measuring apparatuses 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

These are descriptions of one example of the movable body control system to which the technique according to the present disclosure is applicable. Of the configurations that have been described, the technique according to the present disclosure is applicable to the distance measuring apparatus 12031.

Furthermore, the present technology is able to take the following configurations.
(1) A light source apparatus including:
   a photonic crystal-surface emitting laser including at least one light-emitting element in which a plurality of layers is stacked, the plurality of layers including an active layer and a photonic crystal layer; and
   a laser driver electrically coupled to the photonic crystal-surface emitting laser through a bump.
(2) The light source apparatus according to (1), in which
   the photonic crystal-surface emitting laser includes first and second electrodes provided on a side of the laser driver and used to energize the light-emitting element,
   the first electrode is electrically coupled to the laser driver through a first bump, and
   the second electrode is electrically coupled to the laser driver through a second bump.
(3) The light source apparatus according to (2), in which
   the photonic crystal-surface emitting laser includes a pedestal provided alongside the light-emitting element in an in-plane direction,
   the first electrode is provided on a surface of the light-emitting element, the surface being disposed on a side of the laser driver, and
   the second electrode is provided on a surface of the pedestal, the surface being disposed on a side of the laser driver.
(4) The light source apparatus according to (2) or (3), in which
   the photonic crystal-surface emitting laser includes:
   a substrate on which the light-emitting element and the pedestal are provided in a protruding manner; and
   a wiring coupled to the second electrode and extending along the pedestal from a side of the second electrode to a side of the substrate.
(5) The light source apparatus according to (4), in which
   the photonic crystal-surface emitting laser includes an intermediate electrode directly or indirectly provided on the substrate and coupled to the wiring.
(6) The light source apparatus according to (4) or (5), in which
   the photonic crystal-surface emitting laser includes a low-resistance layer provided closer to the substrate than the active layer and the photonic crystal layer, the low-resistance layer having a lower resistance than the substrate.
(7) The light source apparatus according to (6), in which
   the substrate is a semiconductor substrate, and
   the low-resistance layer is a tunnel junction layer.
(8) The light source apparatus according to (6), in which
   the substrate includes a semi-insulating substrate or an insulating substrate, and
   the low-resistance layer includes a current spreading layer.
(9) The light source apparatus according to (2), in which
   the first electrode is provided on a surface of the light-emitting element, the surface being on a side of the laser driver, and
   the second electrode is provided on a surface of the light-emitting element, the surface being on a side of the laser driver.
(10) The light source apparatus according to (9), in which
   the photonic crystal-surface emitting laser includes:
   a substrate on which the light-emitting element is provided in a protruding manner; and
   a wiring coupled to the second electrode and extending along the light-emitting element from a side of the second electrode to a side of the substrate.
(11) The light source apparatus according to (10), in which
   the photonic crystal-surface emitting laser includes an intermediate electrode directly or indirectly provided on the substrate and coupled to the wiring.
(12) The light source apparatus according to (10) or (11), in which
   the photonic crystal-surface emitting laser includes a low-resistance layer provided closer to the substrate than the active layer and the photonic crystal layer, the low-resistance layer having a lower resistance than the substrate.
(13) The light source apparatus according to (12), in which
   the substrate is a semiconductor substrate, and
   the low-resistance layer is a tunnel junction layer.
(14) The light source apparatus according to (12), in which
   the substrate is a semi-insulating substrate or an insulating substrate, and
   the low-resistance layer is a current spreading layer.
(15) The light source apparatus according to any one of (2) to (14), in which
   the laser driver includes a switching element coupled to either one of the first and second electrodes.
(16) The light source apparatus according to any one of (2) to (15), in which
   the photonic crystal-surface emitting laser includes a plurality of the light-emitting elements arrayed in an in-plane direction,
   the laser driver includes a plurality of switching elements corresponding to the plurality of light-emitting elements, and
   each of the plurality of switching elements is coupled to either one of the first and second electrodes used to energize a corresponding light-emitting element.
(17) The light source apparatus according to any one of (1) to (16), in which
   the photonic crystal-surface emitting laser includes a current confining layer.
(18) The light source apparatus according to any one of (1) to (17), in which
   the photonic crystal-surface emitting laser includes a reflecting mirror provided closer to the laser driver than the active layer and the photonic crystal layer.
(19) The light source apparatus according to any one of (1) to (18), in which
   the light-emitting element includes a small diameter portion on a side of the laser driver or on an opposite side from the side of the laser driver.

The present application claims the benefit of Japanese Priority Patent Application JP2023-014728 filed with the Japan Patent Office on February 2, 2023, the entire contents of which are incorporated herein by reference.

It should be understood that those skilled in the art could reach various modifications, combinations, sub-combinations and alterations on the basis of design requirements and other factors, and they are within the scope of the appended claims or the equivalents thereof.

## Claims

1. A light source apparatus comprising:
a photonic crystal-surface emitting laser including at least one light-emitting element in which a plurality of layers is stacked, the plurality of layers including an active layer and a photonic crystal layer; and
a laser driver electrically coupled to the photonic crystal-surface emitting laser through a bump.

2. The light source apparatus according to claim 1, wherein
the photonic crystal-surface emitting laser includes first and second electrodes provided on a side of the laser driver and used to energize the light-emitting element,
the first electrode is electrically coupled to the laser driver through a first bump, and
the second electrode is electrically coupled to the laser driver through a second bump.

3. The light source apparatus according to claim 2, wherein
the photonic crystal-surface emitting laser includes a pedestal provided alongside the light-emitting element in an in-plane direction,
the first electrode is provided on a surface of the light-emitting element, the surface being disposed on a side of the laser driver, and
the second electrode is provided on a surface of the pedestal, the surface being disposed on a side of the laser driver.

4. The light source apparatus according to claim 3, wherein
the photonic crystal-surface emitting laser includes:
a substrate on which the light-emitting element and the pedestal are provided in a protruding manner; and
a wiring coupled to the second electrode and extending along the pedestal from a side of the second electrode to a side of the substrate.

5. The light source apparatus according to claim 4, wherein
the photonic crystal-surface emitting laser includes an intermediate electrode directly or indirectly provided on the substrate and coupled to the wiring.

6. The light source apparatus according to claim 4, wherein
the photonic crystal-surface emitting laser includes a low-resistance layer provided closer to the substrate than the active layer and the photonic crystal layer, the low-resistance layer having a lower resistance than the substrate.

7. The light source apparatus according to claim 6, wherein
the substrate comprises a semiconductor substrate, and
the low-resistance layer comprises a tunnel junction layer.

8. The light source apparatus according to claim 6, wherein
the substrate includes a semi-insulating substrate or an insulating substrate, and
the low-resistance layer includes a current spreading layer.

9. The light source apparatus according to claim 2, wherein
the first and second electrodes are provided on a surface of the light-emitting element, the surface being on a side of the laser driver.

10. The light source apparatus according to claim 9, wherein
the photonic crystal-surface emitting laser includes:
a substrate on which the light-emitting element is provided in a protruding manner; and
a wiring coupled to the second electrode and extending along the light-emitting element from a side of the second electrode to a side of the substrate.

11. The light source apparatus according to claim 10, wherein
the photonic crystal-surface emitting laser includes an intermediate electrode directly or indirectly provided on the substrate and coupled to the wiring.

12. The light source apparatus according to claim 10, wherein
the photonic crystal-surface emitting laser includes a low-resistance layer provided closer to the substrate than the active layer and the photonic crystal layer and having a lower resistance than the substrate.

13. The light source apparatus according to claim 12, wherein
the substrate comprises a semiconductor substrate, and
the low-resistance layer comprises a tunnel junction layer.

14. The light source apparatus according to claim 12, wherein
the substrate comprises a semi-insulating substrate or an insulating substrate, and
the low-resistance layer comprises a current spreading layer.

15. The light source apparatus according to claim 2, wherein
the laser driver includes a switching element coupled to either one of the first and second electrodes.

16. The light source apparatus according to claim 2, wherein
the photonic crystal-surface emitting laser includes a plurality of the light-emitting elements arrayed in an in-plane direction,
the laser driver includes a plurality of switching elements corresponding to the plurality of light-emitting elements, and
each of the plurality of switching elements is coupled to either one of the first and second electrodes used to energize a corresponding light-emitting element.

17. The light source apparatus according to claim 1, wherein
the photonic crystal-surface emitting laser includes a current confining layer.

18. The light source apparatus according to claim 1, wherein
the photonic crystal-surface emitting laser includes a reflecting mirror provided closer to the laser driver than the active layer and the photonic crystal layer.

19. The light source apparatus according to claim 1, wherein
the light-emitting element includes a small diameter portion on a side of the laser driver or on an opposite side from the side of the laser driver.
